# EUROPEAN PATENT SPECIFICATION

(11) **EP 4 426 080 B1**
(45) Date of publication and mention of the grant of the patent: **11.02.2026**
(21) Application number: 22899148.5
(22) Date of filing: 29.11.2022
(51) Int. Cl.: H04M 1/02, G06F 1/16, G06F 3/041, H05K 9/00, H04M 1/18

(54) **ELECTRONIC DEVICE COMPRISING MAGNETIC SHIELDING STRUCTURE**
ELEKTRONISCHE VORRICHTUNG MIT MAGNETISCHER ABSCHIRMSTRUKTUR
DISPOSITIF ÉLECTRONIQUE COMPRENANT UNE STRUCTURE DE BLINDAGE MAGNÉTIQUE

(30) Priority: 29.11.2021 KR 20210167563; 17.01.2022 KR 20220006502; 01.07.2022 KR 20220081214
(43) Date of publication of application: 04.09.2024
(73) Proprietor: Samsung Electronics Co., Ltd., Suwon-si, Gyeonggi-do 16677 (KR)
(72) Inventor: OH, Myeongsu, Suwon-si, Gyeonggi-do 16677 (KR); JUNG, Kiyoung, Suwon-si, Gyeonggi-do 16677 (KR); KIM, Yongyoun, Suwon-si, Gyeonggi-do 16677 (KR); AN, Jungchul, Suwon-si, Gyeonggi-do 16677 (KR); CHU, Duho, Suwon-si, Gyeonggi-do 16677 (KR)
(74) Representative: Nederlandsch Octrooibureau
(86) International application number: PCT/KR2022/019097
(87) International publication number: WO 2023/096466

(56) References cited:
- WO-A1-2020/218796
- WO-A1-2021/225324
- KR-A- 20200 090 476
- KR-A- 20200 108 754
- KR-A- 20210 040 699
- KR-A- 20210 097 650
- US-A1- 2020 137 908

## Description

### [Technical Field]

Various embodiments disclosed in this document relate to an electronic device including a magnetic shielding structure.

### [Background Art]

As more information is visually displayed, and an electronic device supports more functions, users who desire a larger-screen display are increasing. A new type of electronic device has been developed to provide a large-screen display while maintaining a size that is easy to be carried.

With the development of display technology, a foldable display has become able to be implemented. An electronic device in the form in which an area for displaying information is varied through folding by using such a display has been released.

An electronic device can support various kinds of pen input devices. A certain electronic device may include a display module in which a separate constituent element (e.g., digitizer) for recognizing an input of a pen input device exists.

A shielding structure for an electronic component included in the electronic device to operate with a specified quality may be required.

WO 2020/218796 A1 discloses an electronic device with a foldable housing comprising a flexible display and a digitiser panel, as well as a magnetic shield member on the rear surface of the digitiser panel.

KR 2020 0090476 A discloses an electronic device comprising a foldable housing, a flexible display, a digitiser, two magnets and two magnet shield members.

### [Disclosure of Invention]

### [Technical Problem]

Various electronic components included in an electronic device may be connected to ground that provides a reference electric potential for operating the electronic components.

For example, a conductive material may be disposed on a rear surface of a digitizer panel that recognizes an input of a pen by using an electromagnetic resonance phenomenon, and this conductive material may function as a ground of the digitizer panel.

In an electronic device, various constituent elements formed of different materials may be disposed. In order to dispose such constituent elements, a gap space may be required. Further, in order to secure a surface quality (e.g., flatness) of a display module of the electronic device, a free space between the constituent elements may be required.

Due to various reasons including the above-described reason, a part of an electronic component may be exposed without ground. For example, a part of the digitizer panel may be exposed without being hidden by a conductive material.

Current having been abandoned in such an exposed portion may act as a noise on other electronic components, and may exert an influence on the operations of the other electronic components.

Various embodiments disclosed in this document may present various structures which can reduce the problems caused by the current abandoned into the exposed portion by reducing the portion where the electronic component is exposed while securing the free space for disposing various constituent elements as it is.

### [Solution to Problem]

An electronic device according to the present invention is defined in independent claim 1.

An electronic device according to further embodiments disclosed in this document is defined in the dependent claims.

### [Advantageous Effects of Invention]

According to various embodiments disclosed in this document, it is possible to reduce a problem in that current being generated by an operation of an electronic component (e.g., digitizer panel) exerts an influence on other electronic components by reducing a part where the electronic component is exposed without ground.

### [Brief Description of Drawings]

In relation to the description of the drawings, the same or similar reference numerals may be used for the same or similar constituent elements.
FIGS. 1A and 1B are views illustrating an unfolded state of an electronic device when viewed from a front surface and a rear surface of the electronic device according to various embodiments of the disclosure.
FIGS. 2A and 2B are views illustrating a folded state of an electronic device when viewed from a front surface and a rear surface of the electronic device according to various embodiments of the disclosure.
FIG. 3 is an exploded perspective view of an electronic device according to various embodiments of the disclosure.
FIG. 4 is an exploded perspective view of a first display according to various embodiments of the disclosure.
FIG. 5 is a constitutional diagram of reinforcing plates according to various embodiments of the disclosure.
FIG. 6 is a view illustrating a rear structure of a flexible display according to various embodiments of the disclosure.
FIG. 7 is a schematic diagram of a display module illustrated in FIG. 6, in which the display module is cut along line X-X, and cross sections of the display module and surrounding constituent elements are schematized.
FIG. 8A is a cross-sectional view of an electronic device illustrated in FIG. 1A, cut along line B-B of FIG. 1A.
FIG. 8B is a schematic diagram in which the drawing illustrated in FIG. 8A is schematized.
FIG. 8C is a cross-sectional schematic diagram of a shielding member according to various embodiments disclosed in this document.
FIG. 9A is a cross-sectional view of an electronic device illustrated in FIG. 1A, cut along line B-B of FIG. 1A.
FIG. 9B is a schematic diagram in which the drawing illustrated in FIG. 9A is schematized.
FIG. 9C is a cross-sectional schematic diagram of a shielding member according to various embodiments disclosed in this document.
FIG. 10A is a cross-sectional view of an electronic device illustrated in FIG. 1A, cut along line B-B of FIG. 1A.
FIG. 10B is a schematic diagram in which the drawing illustrated in FIG. 10A is schematized.
FIG. 11A is a cross-sectional view of an electronic device illustrated in FIG. 1A, cut along line B-B of FIG. 1A.
FIG. 11B is a schematic diagram in which the drawing illustrated in FIG. 11A is schematized.
FIG. 11C is a cross-sectional schematic diagram of a shielding member according to various embodiments disclosed in this document.
FIG. 12A is a cross-sectional view of an electronic device illustrated in FIG. 1A, cut along line B-B of FIG. 1A.
FIG. 12B is a schematic diagram in which the drawing illustrated in FIG. 12A is schematized.
FIGS. 13A and 13B are diagrams capable of identifying an antenna radiation deviation of an electronic device according to various embodiments disclosed in this document.
FIG. 14A is an enlarged view of S1 illustrated in FIG. 6.
FIG. 14B is a cross-sectional view of an electronic device illustrated in FIG. 14A, cut along line C-C of FIG. 14A.
FIG. 15A is an enlarged view of S1 illustrated in FIG. 6.
FIG. 15B is a cross-sectional view of an electronic device illustrated in FIG. 15A, cut along line C-C of FIG. 15A.
FIG. 16A is an enlarged view of S1 illustrated in FIG. 6.
FIG. 16B is a cross-sectional view of an electronic device illustrated in FIG. 16A, cut along line C-C of FIG. 16A.
FIG. 17A is an enlarged view of S2 illustrated in FIG. 6.
FIG. 17B is a cross-sectional view of an electronic device illustrated in FIG. 17A, cut along line D-D of FIG. 17A.
FIG. 18A is an enlarged view of S2 illustrated in FIG. 6.
FIG. 18B is a cross-sectional view of an electronic device illustrated in FIG. 18A, cut along line D-D of FIG. 18A.
FIG. 19 is a diagram capable of identifying an antenna radiation deviation of an electronic device illustrated in FIGS. 14A to 18B.

### [Mode for the Invention]

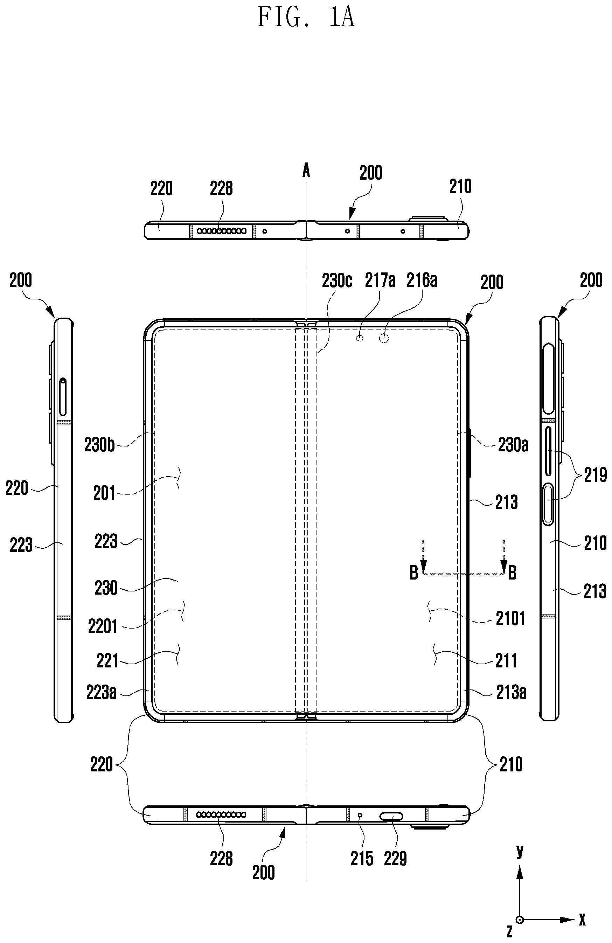

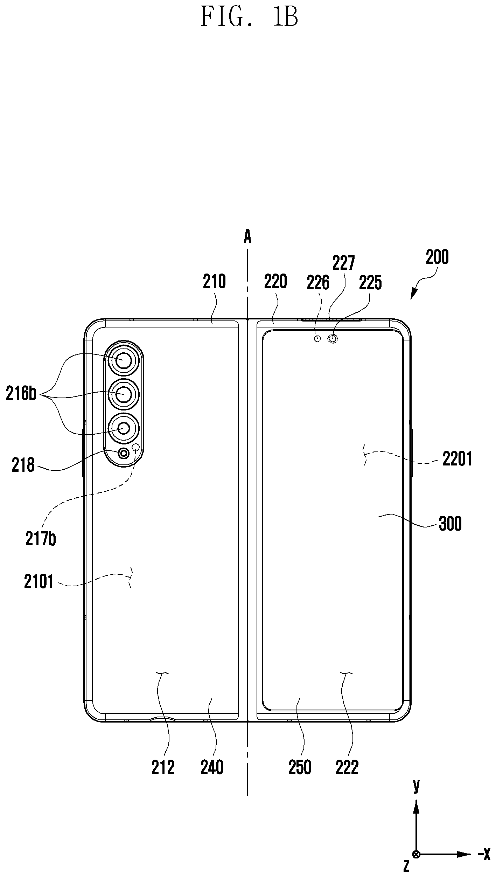

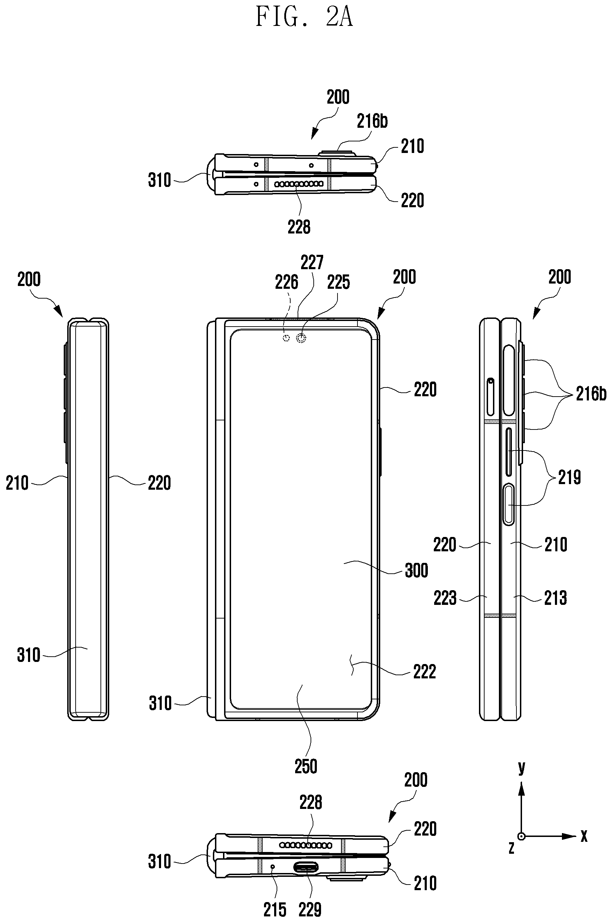

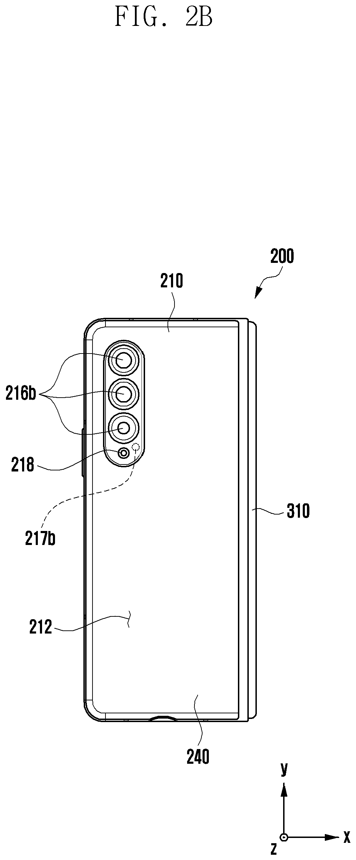

FIGS. 1A and 1B illustrate a front view and a rear view of an unfolded state of an electronic device according to various embodiments of the disclosure. FIGS. 2A and 2B illustrate a front view and a rear view of a folded state of an electronic device according to various embodiments of the disclosure.

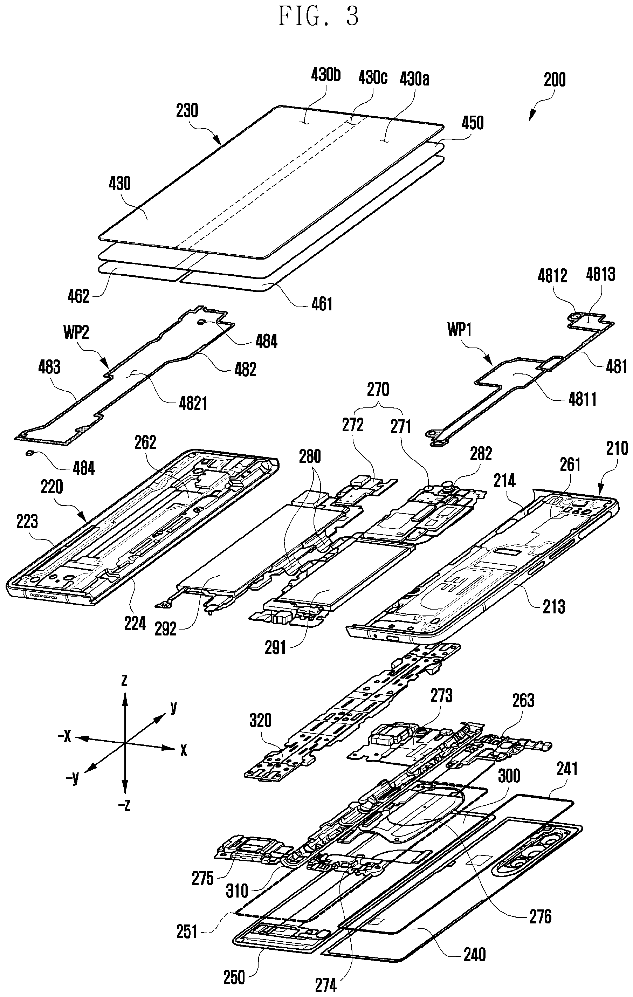

Referring to FIGS. 1A to 2B, an electronic device 200 may include a pair of housings 210 and 220 (e.g., a foldable housing structure) rotatably coupled to each other with reference to folding axis A through a hinge device (e.g., a hinge device 320 of FIG. 3) (e.g., a hinge module) so as to be folded with respect to each other, a first display 230 (e.g., a flexible display, a foldable display, or a main display) disposed through the pair of housings 210 and 220, and/or a second display 300 (e.g., a sub display) disposed through the second housing 220. According to an embodiment, at least a part of the hinge device (e.g., the hinge device 320 of FIG. 3) may be disposed so as not to be seen from the outside through the first housing 210 and the second housing 220, and may be disposed so as not to be seen from the outside through the hinge housing 310 covering a foldable portion. In the disclosure, a surface in which the first display 230 is disposed may be defined as a front surface of the electronic device 200, and a surface opposite to the front surface may be defined as a rear surface of the electronic device 200. In addition, a surface surrounding a space between the front surface and the rear surface may be defined as a side surface of the electronic device 200.

According to various embodiments, the pair of housings 210 and 220 may include a first housing 210 and a second housing 220 foldably arranged with respect to each other through the hinge device (e.g., the hinge device 320 of FIG. 3). According to an embodiment, the shape and the coupling of the pair of housings 210 and 220 are not limited to those illustrated in FIGS. 1A to 2B, and the pair of housings 210 and 220 may be implemented by a combination and/or coupling of other shapes or components. According to an embodiment, the first housing 210 and the second housing 220 may be arranged on opposite sides with reference to the folding axis A, and may have shapes that are entirely symmetric to each other with respect to the folding axis A. According to an embodiment, the first housing 210 and the second housing 220 may be asymmetrically folded with reference to the folding axis A. According to an embodiment, the angle or the distance between the first housing 210 and the second housing 220 may vary depending on whether the electronic device 200 is in an unfolded state, a folded state, or an intermediate state.

According to various embodiments, the first housing 210 may include, in the unfolded state of the electronic device 200, a first surface 211 connected to the hinge device (e.g., the hinge device 320 of FIG. 3) and disposed to be oriented to the front surface of the electronic device 200, a second surface 212 oriented in a direction opposite to the first surface 211, and/or a first side member 213 surrounding at least a part of a first space between the first surface 211 and the second surface 212. According to an embodiment, the second housing 220 may include, in the unfolded state of the electronic device 200, a third surface 221 connected to the hinge device (e.g., the hinge device 320 of FIG. 3) and disposed to be oriented to the front surface of the electronic device 200, a fourth surface 222 oriented in a direction opposite to the third surface 221, and/or a second side member 223 surrounding at least a part of a second space between the third surface 221 and the fourth surface 222. According to an embodiment, the first surface 211 and the third surface 221 may be oriented in substantially the same direction in the unfolded state, and the first surface 211 and the third surface 221 may at least partially face each other in the folded state. According to an embodiment, the electronic device 200 may include a recess 201 formed to receive the first display 230 through structural coupling of the first housing 210 and the second housing 220. According to an embodiment, the recess 201 may have substantially the same shape as the first display 230.

According to various embodiments, the hinge housing 310 (e.g., a hinge cover) may be disposed between the first housing 210 and the second housing 220, and may be disposed to cover a part (e.g., at least one hinge module) of the hinge device (e.g., the hinge device 320 of FIG. 3) disposed on the hinge housing 310. According to an embodiment, the hinge housing 310 may be hidden or exposed from or to the outside by a part of the first housing 210 and the second housing 220 according to the unfolded state, the folded state, or the intermediate state of the electronic device 200. For example, when the electronic device 200 is in the unfolded state, at least a part of the hinge housing 310 may be covered by the first housing 210 and the second housing 220 and not be substantially exposed. According to an embodiment, when the electronic device 200 is in the folded state, at least a part of the hinge housing 310 may be exposed to the outside between the first housing 210 and the second housing 220. According to an embodiment, in the intermediate state in which the first housing 210 and the second housing 220 are folded with each other by a predetermined angle (folded with a certain angle), the hinge housing 310 may be at least partially exposed to the outside of the electronic device 200 between the first housing 210 and the second housing 220. For example, an area in which the hinge housing 310 is exposed to the outside may be smaller than that in a case in which the electronic device 200 is completely folded. According to an embodiment, the hinge housing 310 may include a curved surface.

According to various embodiments, when the electronic device 200 is in the unfolded state (e.g., the states shown in FIGS. 1A and 1B), the first housing 210 and the second housing 220 may meet at an about 180-degree angle, and a first area 230a, a second area 230b, and a folding area 230c of the first display 230 may form the same plane and arranged to be oriented in substantially the same direction (e.g., a z-axis direction). In another embodiment, when the electronic device 200 is in the unfolded state, the first housing 210 may rotate by an about 360-degree angle with respect to the second housing 220, and may be outwardly folded (an out-folding scheme) so that the second surface 212 and the fourth surface 222 face each other.

According to various embodiments, when the electronic device 200 is in the folded state (e.g., the states shown in FIGS. 2A and 2B), the first surface 211 of the first housing 210 and the third surface 221 of the second housing 220 may be arranged to face each other. In this case, the first area 230a and the second area 230b of the first display 230 may form a narrow angle (e.g., a range between 0 degree to about 10 degrees) through the folding area 230c, and may be arranged to face each other. According to an embodiment, at least a part of the folding area 230c may be deformed into a curved shape having a predetermined curvature. According to an embodiment, when the electronic device 200 is in the intermediate state, the first housing 210 and the second housing 220 may be arranged at a predetermined angle (a certain angle). In this case, the first area 230a and the second area 230b of the first display 230 may form an angle that is greater than that in the folded state and smaller than that in the unfolded state, and the curvature of the folding area 230c may be lower than that in the folded state, and may be higher than that in the unfolded state. In an embodiment, the first housing 210 and the second housing 220 may form an angle which allows stopping at a designated folding angle between the folded state and the unfolded state (a free stop function), through the hinge device (e.g., the hinge device 320 of FIG. 3). In an embodiment, the first housing 210 and the second housing 220 may continuously operate while being pressed in an unfolding direction or a folding direction with reference to a designated inflection angle, through the hinge device (e.g., the hinge device 320 of FIG. 3).

According to various embodiments, the electronic device 200 may include at least one of at least one display 230 and 300 disposed on the first housing 210 and/or the second housing 220, an input device 215, sound output devices 227 and 228, sensor modules 217a, 217b, and 226, camera modules 216a, 216b, and 225, a key input device 219, an indicator (not shown), or a connector port 229. In an embodiment, the electronic device 200 may omit at least one of the elements, or may additionally include at least one another element.

According to various embodiments, the at least one display 230 and 300 may include a first display 230 (e.g., a flexible display) disposed to be supported by the third surface 221 of the second housing 220 from the first surface 211 of the first housing 210 through the hinge device (e.g., the hinge device 320 of FIG. 3), and a second display 300 disposed to be at least partially seen from the outside through the fourth surface 222 in a space in the second housing 220. In an embodiment, the second display 300 may be disposed to be seen from the outside through the second surface 212 in a space in the first housing 210. According to an embodiment, the first display 230 may be mainly used in the unfolded state of the electronic device 200, and the second display 300 may be mainly used in the folded state of the electronic device 200. According to an embodiment, the electronic device 200 may control, in the intermediate state, the first display 230 and/or the second display 300 to be used, based on a folding angle between the first housing 210 and the second housing 220.

According to various embodiments, the first display 230 may be disposed in a receiving space formed by the pair of housings 210 and 220. For example, the first display 200 may be disposed in a recess 201 formed by the pair of housings 210 and 220, and may be disposed to occupy substantially the most of the front surface of the electronic device 200in the unfolded state. According to an embodiment, the first display 230 may include a flexible display having at least one area which can be deformed into a plane or a curved surface. According to an embodiment, the first display 230 may include the first area 230a facing the first housing 210 and the second area 230b facing the second housing 220. According to an embodiment, the first display 230 may include the folding area 230c including a part of the first area 230a and a part of the second area 230b with respect to the folding axis A. According to an embodiment, at least a part of the folding area 230c may include an area corresponding to the hinge device (e.g., the hinge device 320 of FIG. 3). According to an embodiment, a division of an area of the first display 230 merely corresponds to exemplary physical division by the pair of housings 210 and 220 and the hinge device (e.g., the hinge device 320 of FIG. 3), and the first display 230 may be substantially displayed as one seamless full screen through the pair of the housings 210 and 220 and the hinge device (e.g., the hinge device 320 of FIG. 3). According to an embodiment, the first area 230a and the second area 230b may have shapes that are entirely symmetric or partially asymmetric to each other with respect to the folding area 230c.

According to various embodiments, the electronic device 200 may include a first rear cover 240 disposed on the second surface 212 of the first housing 210 and a second rear cover 250 disposed on the fourth surface 222 of the second housing 220. In an embodiment, at least a part of the first rear cover 240 may be integrally formed with the first side member 213. In an embodiment, at least a part of the second rear cover 250 may be integrally formed with the second side member 223. According to an embodiment, at least one of the first rear cover 240 and the second rear cover 250 may be substantially formed of a transparent plate (e.g., a polymer plate or glass plate including various coding layers) or an opaque plate. According to an embodiment, the first rear cover 240 may be formed of, for example, an opaque plate such as coded or colored glass, ceramic, polymer, metal (e.g., aluminum, stainless steel (STS), or magnesium), or a combination of at least two of the materials above. According to an embodiment, the second rear cover 250 may be substantially formed of, for example, a transparent plate such as glass or polymer. Accordingly, the second display 300 may be disposed to be seen from the outside through the second rear cover 250 in a space in the second housing 220.

According to various embodiments, the input device 215 may include a microphone. In an embodiment, the input device 215 may include multiple microphones arranged to detect the direction of sound. According to an embodiment, the sound output devices 227 and 228 may include speakers. According to an embodiment, the sound output devices 227 and 228 may include a call receiver 227 disposed through the fourth surface 222 of the second housing 220 and an external speaker 228 disposed through at least a part of the second side member 223 of the second housing 220. In an embodiment, the input device 215, the sound output devices 227 and 228, and the connector 229 may be disposed in spaces of the first housing 210 and/or the second housing 220, and may be exposed to an external environment through at least one hole formed through the first housing 210 and/or the second housing 220. In an embodiment, holes formed through the first housing 210 and/or the second housing 220 may be commonly used for the input device 215 and the sound output devices 227 and 228. In an embodiment, the sound output devices 227 and 228 may include a speaker (e.g., a piezo speaker) operating without including a hole formed through the first housing 210 and/or the second housing 220.

According to various embodiments, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220. According to an embodiment, the electronic device 200 may include a flash 218 disposed around the second camera module 216b. According to an embodiment, the flash 218 may include, for example, a light-emitting diode or a xenon lamp. According to an embodiment, the camera modules 216a, 216b, and 225 may include one or multiple lenses, an image sensor, and/or an image signal processor. In an embodiment, at least one of the camera modules 216a, 216b, and 225 may include two or more lenses (e.g., wide-angle and telephoto lenses) and image sensors, and may be arranged together on one surface of the first housing 210 and/or the second housing 220.

According to various embodiments, the sensor modules 217a, 217b, and 226 may generate a data value or an electrical signal corresponding to an internal operational state or an external environmental state of the electronic device 200.According to an embodiment, the sensor modules 217a, 217b, and 226 may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220. In an embodiment, the sensor modules 217a, 217b, and 226 may include at least one of a gesture sensor, a grip sensor, a color sensor, an infrared (IR) sensor, an illuminance sensor, an ultrasonic sensor, an iris recognition sensor, or a distance detection sensor (e.g., a time of flight (TOF) sensor or a light detection and ranging (LiDAR)).

According to various embodiments, the electronic device 200 may further include a non-illustrated sensor module, for example, at least one of an atmospheric sensor, a magnetic sensor, a biometric sensor, a temperature sensor, a humidity sensor, or a fingerprint recognition sensor. In an embodiment, the fingerprint recognition sensor may be disposed through at least one of the first side member 213 of the first housing 210 and/or the second side member 223 of the second housing 220.

According to various embodiments, the key input device 219 may be disposed to be exposed to the outside through the first side member 213 of the first housing 210. In an embodiment, the key input device 219 may be disposed to be exposed to the outside through the second side member 223 of the second housing 220. In an embodiment, the electronic device 200 may not include some or all of the key input device 219, and the non-included key input device 219 may be implemented in another shape such as a soft key on the least one display 230 and 300. In another embodiment, the key input device 219 may be implemented by using a pressure sensor included in the at least one display 230 and 300.

According to various embodiments, the connector port 229 may include a connector (e.g., a USB connector or an IF module (an interface connector port module)) for transmitting or receiving data and/or power to and/or from an external electronic device. In an embodiment, the connector port 229 may perform a function of transmitting or receiving an audio signal to or from the external electronic device together, or may further include a separate connector port (e.g., an ear jack hole) for performing a function of transmitting or receiving an audio signal to or from the external electronic device.

According to various embodiments, at least one camera modules 216a and 225 of the camera modules 216a, 216b, and 225, at least one sensor module 217a and 226 of the sensor modules 217a, 217b, and 226, and/or an indicator may be arranged to be exposed through the at least one display 230 and 300. For example, the at least one camera modules 216a and 225, the at least one sensor module 217a and 226, and/or the indicator may be arranged under an activated area (a display area) of the at least one display 230 and 300 in a space in the at least one housing 210 and 220, and may be arranged to come into contact with an external environment through a transparent area or an opening that is perforated to a cover member (e.g., a window layer (not shown) of the first display 230 and/or the second rear cover 250). According to an embodiment, an area in which the at least one display 230 and 300 and the at least one camera module 216a and 225 face each other may be formed as a transmission area having a predetermined transmission ratio, as a part of an area in which a content is displayed. According to an embodiment, the transmission area may be formed to have a transmission ratio in the range of about 5% to about 20%. The transmission area may include an area overlapping with an effective area (e.g., an angle of view area) of the at least one camera module 216a and 225, wherein an image is formed on the image sensor in the effective area, and light for generating an image passes through the effective area. For example, the transmission area of the display 230 and 300 may include an area in which the density of a pixel is lower than that in a surrounding area. For example, the transmission area may be replaced with an opening. For example, the at least one camera module 216a and 225 may include an under-display camera (UDC) or an under-panel camera (UPC). In another embodiment, some camera modules or sensor modules 271a and 226 may be arranged to perform functions thereof without being visually exposed through the display. For example, an area facing the sensor module 217a and 226 and/or the camera module 216a and 225 arranged under the display 230 and 300 (e.g., a display panel) corresponds to an under-display camera (UDC) structure, and a perforated opening is not necessarily required.

FIG. 3 is an exploded perspective view illustrating an electronic device 200 according to various embodiments of the disclosure.

Referring to FIG. 3, the electronic device 200 may include a first display 230 (e.g., a flexible display), a second display 300, a hinge device 320, a pair of support members 261 and 262, at least one substrate 270 (e.g., a printed circuit board (PCB)), a first housing 210, a second housing 220, a first rear cover 240, and/or a second rear cover 250.

According to various embodiments, the first display 230 may include a display panel 430 (e.g., a flexible display panel), a support plate 450 disposed under the display panel 430, and a pair of reinforcing plates 461 and 462 arranged under the support plate 450. According to an embodiment, the display panel 430 may include a first panel area 430a corresponding to a first area (e.g., the first area 230a of FIG. 1A) of the first display 230, a second panel area 430b extending from the first panel area 430a and corresponding to a second area (e.g., the second area 230b of FIG. 1A) of the first display 230, and a third panel area 430c for connecting the first panel area 430a and the second panel area 430b and corresponding to a folding area (e.g., the folding area 230c of FIG. 1A) of the first display 230. According to an embodiment, the support plate 450 may be disposed between the display panel 430 and the pair of support members 261 and 262 and may be formed to have a material and a shape for providing a planar support structure for the first panel area 430a and the second panel area 430b and a bendable structure for assisting in the flexibility of the third panel area 430c. According to an embodiment, the support plate 450 may be formed of a conductive material (e.g., metal) or a non-conductive material (e.g., polymer or fiber reinforcing plastic (FRP)). According to an embodiment, the pair of reinforcing plates 461 and 462 may include, between the support plate 450 and the pair of support members 261 and 262, a first reinforcing plate 461 disposed to correspond to at least a part of the first panel 430a and the third panel area 430c, and a second reinforcing plate 462 disposed to correspond to at least a part of the second panel area 460b and the third panel area 430c. According to an embodiment, the pair of reinforcing plates 461 and 462 may be formed of metal materials (e.g., SUS), and may thus assist in reinforcing of the rigidity and a ground connection structure for the first display 230.

According to various embodiments, the second display 300 may be disposed in a space between the second housing 220 and the second rear cover 250. According to an embodiment, the second display 300 may be disposed in a space between the second housing 220 and the second rear cover 250 so as to allow the second display 300 to be seen from the outside through substantially the entire area of the second rear cover 250.

According to various embodiments, at least a part of the first support member 261 may be bendably coupled to the second support member 262 through the hinge device 320. According to an embodiment, the electronic device 200 may include at least one wire member 280 (e.g., a flexible printed circuit board (FPCB)) disposed from at least a part of the first support member 261 to a part of the second support member 262 by crossing the hinge device 320. According to an embodiment, the first support member 261 may be disposed by extending from the first side member 213 or structurally coupled to the first side member 213. According to an embodiment, the electronic device 200 may include a first space (e.g., a first space 2101 of FIG. 1A) provided through the first support member 261 and the first rear cover 240. According to an embodiment, the first housing 210 (e.g., a first housing structure) may be configured by coupling of the first side member 213, the first support member 261, and the first rear cover 240. According to an embodiment, the second support member 262 may be disposed by extending from the second side member 223 or structurally coupled to the second side member 223. According to an embodiment, the electronic device 200 may include a second space (e.g., a second space 2201 of FIG. 1A) provided through the second support member 262 and the second rear cover 250. According to an embodiment, the second housing 220 (e.g., a second housing structure) may be configured through coupling of the second side member 223, the second support member 262, and the second rear cover 250. According to an embodiment, at least a part of the hinge device 320 and/or the at least one wire member 280 may be disposed to be supported through at least a part of the pair of support members 261 and 262. According to an embodiment, the at least one wire member 280 may be disposed in a direction (e.g., an x-axis direction) crossing the first support member 261 and the second support member 262. According to an embodiment, the at least one wire member 280 may be disposed in a direction (e.g., an x-axis direction) substantially perpendicular to a folding axis (e.g., a y-axis or the folding axis A of FIG. 1A).

According to various embodiments, the at least one substrate 270 may include a first substrate 271 disposed in the first space 2101 and a second substrate 272 disposed in the second space 2201. According to an embodiment, the first substrate 271 and the second substrate 272 may include multiple electronic components arranged to implement various functions of the electronic device 200. According to an embodiment, the first substrate 271 and the second substrate 272 may be electrically connected to each other through the at least one wire member 280.

According to various embodiments, the electronic device 200 may include at least one battery 291 and 292. According to an embodiment, the at least one battery 291 and 292 may include a first battery 291 disposed in the first space 2101 of the first housing 210 and electrically connected to the first substrate 271, and a second battery disposed in the second space 2201 of the second housing 220 and electrically connected to the second substrate 272. According to an embodiment, the first support member 261 and the second support member 262 may further include at least one swelling hole for the first battery 291 and the second battery 292.

According to various embodiments, the first housing 210 may include a first rotation support surface 214, and the second housing 220 may include a second rotation support surface 224 corresponding to the first rotation support surface 214. According to an embodiment, the first rotation support surface 214 and the second rotation support surface 224 may include a curved surface (seamlessly connected) corresponding to an external surface of a curved shape of the hinge housing 310. According to an embodiment, when the electronic device 200 is in the unfolded state, the first rotation support surface 214 and the second rotation support surface 224 may hide the hinge housing 310 not to expose the hinge housing 310 through the rear surface of the electronic device 200 or to expose only a part thereof. According to an embodiment, when the electronic device 200 in the folded state, the first rotation support surface 214 and the second rotation support surface 224 may be at least partially expose the hinge housing 310 through the rear surface of the electronic device 200 as the curved shape of the hinge housing 310 rotates along an external surface.

According to various embodiments, the electronic device 200 may include at least one antenna 276 disposed in the first space 2201. According to an embodiment, the at least one antenna 276 may be disposed on the first battery 291 and the first rear cover 240 in the first space 2201. According to an embodiment, the at least one antenna 276 may include, for example, a near-field communication (NFC) antenna, a wireless charging antenna, and/or a magnetic secure transmission (MST) antenna. According to an embodiment, the at least one antenna 276 may perform, for example, short-distance communication with an external device, or wirelessly transmit or receive power required for charging. In an embodiment, an antenna structure may be formed by at least a part of the first side member 213 or the second side member 223 and/or a part or a combination of the first support member 261 and the second support member 262.

According to various embodiments, the electronic device 200 may further include at least one electronic component assembly 274 and 275 and/or additional support members 263 and 273 disposed in the first space 2101 and/or the second space 2201. For example, the at least one electronic component assembly may include an interface connector port assembly 274 or the speaker assembly 275.

According to various embodiments, the electronic device 100 may include a first waterproof structure WP1 disposed between the first reinforcing plate 461 and the first support member 261 and a second waterproof structure WP2 disposed between the second reinforcing plate 462 and the second support member 262. According to an embodiment, the first waterproof structure WP1 may include a first waterproof member 481 disposed to have at least one first waterproof space 4811, 4812, and 4813 formed between the first reinforcing plate 461 and the first support member 261. According to an embodiment, the second waterproof structure WP2 may include a second waterproof member 482, a third waterproof member 483, and a fourth waterproof member 484 disposed to have at least one second waterproof space 4821 formed between the second reinforcing plate 462 and the second support member 262. According to an embodiment, the fourth waterproof member 484 may be disposed in a space between the second waterproof member 482 and the third waterproof member 483 spaced apart from each other, to connect the second waterproof member and the third waterproof member to each other.

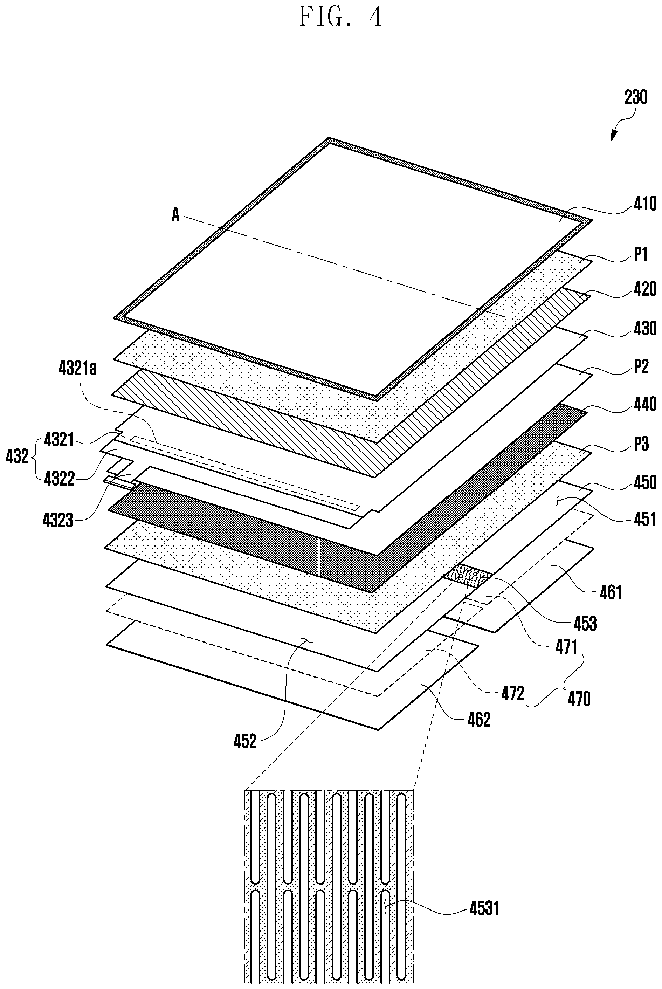

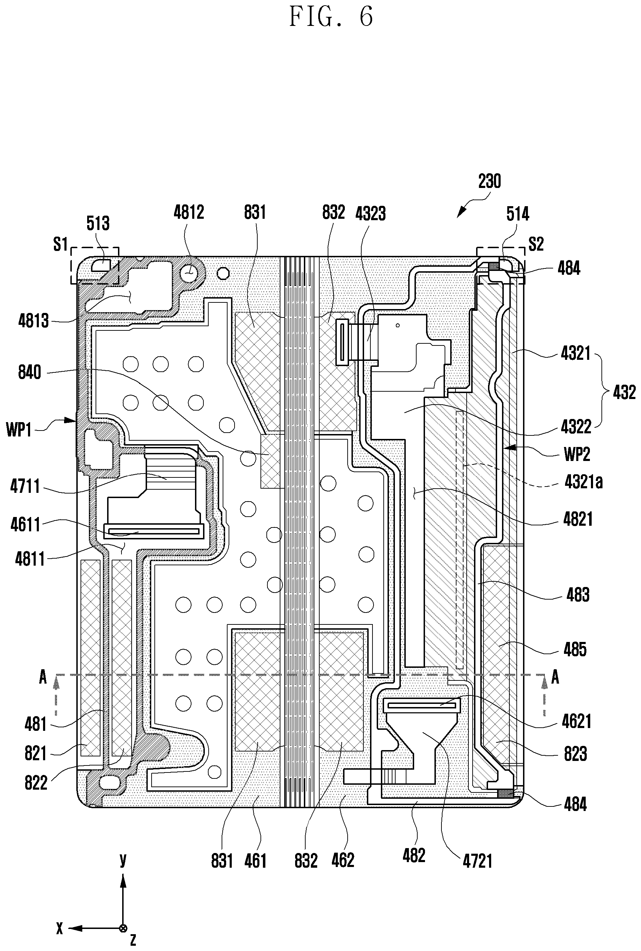

According to various embodiments, the at least one first waterproof space 4811 corresponds to a wire structure for connecting an electronic component (e.g., a first digitizer 471 of FIG. 4) disposed between the first reinforcing plate 461 and the first support member 262 to the first space 2101 through the first waterproof member 481, and may be disposed to receive a through-path of an FPCB connection portion (e.g., a first FPCB connection portion 4711 of FIG. 6). According to an embodiment, the at least one second waterproof space 4821 corresponds to a wire structure for connecting an electronic component (e.g., a second digitizer 472 of FIG. 4) disposed between the second reinforcing plate 462 and the second support member 262 to the second space 2201 through the second waterproof member 482, the third waterproof member 483, and the fourth waterproof member 484, and may be disposed to receive a through-path of an FPCB connection (e.g., a second FPCB connection 4721 of FIG. 6). According to an embodiment, the at least one first waterproof space 4812 and 4813 may receive an area corresponding to at least one electronic component (e.g., a camera module or a sensor module) disposed to be supported by the first support member 261. According to an embodiment, the at least one second waterproof space 4821 may receive at least a part of a bending portion (e.g., a bending portion 432 of FIG. 4) bent over a rear surface of the first display 230. For example, the at least one second waterproof space 4821 may be disposed to extend from a display panel (e.g., a display panel 430 of FIG. 4) of the first display 230 and surround at least a part of the bending portion 432 bent over the rear surface. Accordingly, multiple electrical elements (not shown) and a control circuit (e.g., a control circuit 4321a of FIG. 4) disposed on the bending portion 432 may be disposed in the at least one second waterproof space 4821, so as to be protected from water and/or a foreign material from the outside.

In the electronic device 200 according to an exemplary embodiment of the disclosure, the at least one waterproof member 481, 482, 483, and 484 may include at least one waterproof structure WP1 and WP2 disposed between the first support member 261 of the first housing 210 and the first reinforcing plate 461 and/or between the second support member 262 of the second housing 220 and the second reinforcing plate 462, so that a phenomenon in which the first display is damaged when the first display 230 is separated from the housings 210 and 220 for maintenance of the electronic device 200 can be reduced through a waterproof member, and the at least one waterproof member 481, 482, 483, and 484 is disposed to avoid the rear surface of the first display 230, and thus, external visibility can be enhanced and a surface quality can be secured.

FIG. 4 is an exploded perspective view of a first display according to various embodiments of the disclosure. The display module of FIG. 4 may be an example of a first display (e.g., first display 230 of FIGS. 1A and 3) as described above with reference to FIGS. 1A and 3.

A flexible display module 230 according to exemplary embodiments of the disclosure may include an unbreakable (UB) type OLED display (e.g., curved display). However, the flexible display module 230 is not limited thereto, and may also include an on cell touch (OCTA) active matrix organic light-emitting diode (AMOLED) type flat display.

With reference to FIG. 4, the flexible display module 230 may include a window layer 410, a polarizing (polarizer (POL)) layer 420 (e.g., polarizing film), a display panel 430, a polymer layer 440, a support plate 450, and reinforcing plates 461 and 462, which are sequentially disposed on a rear surface (e.g., -z-axis direction) of the window layer 410. In a certain embodiment, the flexible display module 230 may include a digitizer panel 470 disposed between the support plate 450 and the reinforcing plates 461 and 462. In a certain embodiment, the digitizer panel 470 may be disposed between the polymer layer 440 and the support plate 450.

According to various embodiments, the window layer 410 may include a glass layer. According to an embodiment, the window layer 410 may include ultrathin glass (UTG). In a certain embodiment, the window layer 410 may include polymer. In this case, the window layer 410 may include polyethylene terephthalate (PET) or polyimide (PI). In a certain embodiment, the window layer 410 may be disposed with a plurality of layers so as to include the glass layer and the polymer.

According to various embodiments, the window layer 410, the polarizing layer 420, the display panel 430, the polymer layer 440, and the support plate 450 may be disposed to cross at least parts of a first surface (e.g., first surface 211 of FIG. 1A) of a first housing (e.g., first housing 210 of FIG. 1A) and a third surface (e.g., third surface 221 of FIG. 1A) of a second housing (e.g., second housing 220 of FIG. 1A). According to an embodiment, the reinforcing plates 461 and 462 may include the first reinforcing plate 461 corresponding to the first housing (e.g., first housing 210 of FIG. 1A) and the second reinforcing plate 462 corresponding to the second housing (e.g., second housing 220 of FIG. 1A). According to an embodiment, the reinforcing plates 461 and 462 may provide stiffness for the flexible display module 230 and may be used as a ground for preventing malfunction of the flexible display module 230. According to an embodiment, the reinforcing plates 461 and 462 may be formed of a metal material. According to an embodiment, the reinforcing plates 461 and 462 may be formed of SUS or AL. According to an embodiment, the window layer 410, the polarizing layer 420, the display panel 430, the polymer layer 440, the support plate 450, and the reinforcing plates 461 and 462 may be attached to one another through adhesives P1, P2, and P3 (or glue). For example, the adhesives P1, P2, and P3 may include at least one of an optical clear adhesive (OCA), pressure sensitive adhesive (PSA), heat-reactive adhesive, general adhesive, or double-sided tape.

According to various embodiments, the display panel 430 may include a plurality of pixels and a wiring structure (e.g., electrode pattern). According to an embodiment, the polarizing layer 420 may selectively let light that is generated from a light source of the display panel 430 and vibrates in a predetermined direction pass through. According to an embodiment, the display panel 430 and the polarizing layer 420 may be integrally formed. According to an embodiment, the flexible display module 230 may include a touch panel (not illustrated).

According to various embodiments, since the polymer layer 440 is disposed under the display panel 430, it may provide a dark background for securing visibility of the display panel 430, and may be formed of a buffer material for buffering. In a certain embodiment, for waterproofing of the flexible display module 230, the polymer layer 440 may be removed, or may be disposed under the support plate 450.

According to various embodiments, the support plate 450 may provide a flexural property to the flexible display module 230. For example, the support plate 450 may be formed of a non-metal thin plate material having a rigid property for supporting the display panel 430, such as fiber reinforcing plastics (FRP) (e.g., carbon fiber reinforcing plastics (CFRP) or glass fiber reinforcing plastics (GFRP)). According to an embodiment, the support plate 450 may include a first flat portion 451 corresponding to a first housing (e.g., first housing 210 of FIG. 1A), a second flat portion 452 corresponding to a second housing (e.g., second housing 220 of FIG. 1A), and a bending portion 453 (or flexible portion) connecting the first flat portion 451 and the second flat portion 452 with each other. According to an embodiment, the bending portion 453 may include a plurality of openings 4531 disposed at designated intervals. According to an embodiment, the flexural property of the bending portion 453 may be determined through at least one of the size, shape, or disposition density of at least some of the plurality of openings 4531. In a certain embodiment, the support plate 450 may be formed of a metal material, such as steel use stainless (SUS) (e.g., stainless steel (STS)), Cu, Al, or metal CLAD (e.g., laminated member in which SUS and Al are alternately disposed). In this case, the support plate 450 may have the plurality of openings formed through the entire area so as to induce the detection operation of the digitizer panel 470 disposed under the support plate 450. According to an embodiment, the support plate 450 may help the stiffness reinforcement of the electronic device (e.g., electronic device 200 of FIG. 1A), and may be used to shield the surrounding noise and to disperse heat being emitted from surrounding heat dissipation components.

According to various embodiments, the display 230 may include the digitizer panel 470 as a detection member disposed under the support plate 450 and configured to receive an input of an electronic pen (e.g., stylus). According to an embodiment, the digitizer panel 470 may include coil members disposed on a dielectric substrate (e.g., dielectric film or dielectric sheet) so as to be able to detect an electromagnetic abandonment type resonance frequency applied from the electronic pen. According to an embodiment, the digitizer panel 470 may include a first digitizer panel 471 corresponding to the first housing (e.g., first housing 210 of FIG. 1A) and a second digitizer panel 472 corresponding to the second housing (e.g., second housing 220 of FIG. 1A). According to an embodiment, the first digitizer panel 471 and the second digitizer panel 472 are electrically connected to substrates (e.g., substrates 271 and 272 of FIG. 3) of the electronic device (e.g., electronic device 200 of FIG. 3) through respective cable members (e.g., first cable member 4711 and a second cable member 4721 of FIG. 6), and thus can operate as one digitizer panel. In a certain embodiment, the first digitizer panel 471 and the second digitizer panel 472 may operate individually.

According to various embodiments, the flexible display module 230 may include at least one functional member (not illustrated) disposed between the polymer layer 440 and the support plate 450 or under the support plate 450. According to an embodiment, the functional member may include a graphite sheet for heat dissipation, added display, force touch FPCB, fingerprint sensor FPCB, antenna radiator for communication, or conductive/nonconductive tape. According to an embodiment, in case that the functional member is unable to be bent, it may be individually disposed on the first housing (e.g., first housing 210 of FIG. 1A) and the second housing (e.g., second housing 220 of FIG. 1A). According to an embodiment, in case that the functional member is able to be bent, it may be disposed from the first housing (e.g., first housing 210 of FIG. 1A) up to the second housing (e.g., second housing 220 of FIG. 1A) through a hinge device (e.g., hinge device 320 of FIG. 3).

According to various embodiments, the flexible display module 230 may include the bending portion 432 disposed in a manner of being folded from the display panel 430 to at least a partial area of a rear surface (e.g., -z-axis direction) of the flexible display module 230. According to an embodiment, the bending portion 432 may include an extension portion 4321 extending from the display panel 430 and including a control circuit 4321a, and a flexible board 4322 electrically connected to the extension part 4321 and including a plurality of electrical elements. According to an embodiment, the control circuit 4321a may include a display driver IC (DDI) or a touch display driver IC (TDDI) mounted on the extension portion 4321 having an electrical wiring structure. According to an embodiment, the control circuit 4321a may have a chip on panel or chip on plastic (COP) structure directly disposed on the extension portion 4321. In a certain embodiment, the control circuit 4321a may have a chip on film (COF) structure mounted on a separate connection film (not illustrated) connecting the extension portion 4321 and the flexible board 4322 with each other. According to an embodiment, the flexible display module 230 may include a plurality of electrical elements (not illustrated) disposed on the flexible board 4322. According to an embodiment, the flexible display module 230 may include a cable member 4323 extending from the flexible board 4322 and electrically connected to the substrate (e.g., second substrate 272 of FIG. 3) of the electronic device (e.g., electronic device 200 of FIG. 3). According to an embodiment, the plurality of electrical elements may include a passive element, such as a touch IC, flash memory for display, diode for ESD prevention, pressure sensor, fingerprint sensor, or decap. As another embodiment, in case that the bending portion 432 is disposed on an area that faces the first housing (e.g., first housing 210 of FIG. 1A) of the flexible display module 230, the cable member 4323 may be electrically connected to another substrate (e.g., first substrate 271 of FIG. 3) of the electronic device (e.g., electronic device 200 of FIG. 3).

According to exemplary embodiments of the disclosure, the electronic device (e.g., electronic device 200 of FIG. 3) may include a waterproof structure provided to protect, from external moisture and/or foreign substances, a wiring structure of the cable member (e.g., cable members 4711 and 4721 of FIG. 6) drawn from the digitizer panel 470 disposed on the rear surface of the flexible display module 230, at least a part (e.g., extension portion 4321) of the bending portion 432 being bent to the rear surface of the flexible display module 230 and including the control circuit 4321a and the plurality of electrical elements, and areas corresponding to at least one electronic component (e.g., camera module or sensor module) disposed through the support members 461 and 462.

The display module 230 as described above is merely one example for explaining the disclosure, and it is not mandatory for the display module 230 to include all constituent elements as described above. Accordingly, some of the above-described constituent elements may be omitted or added to constitute the display module 230.

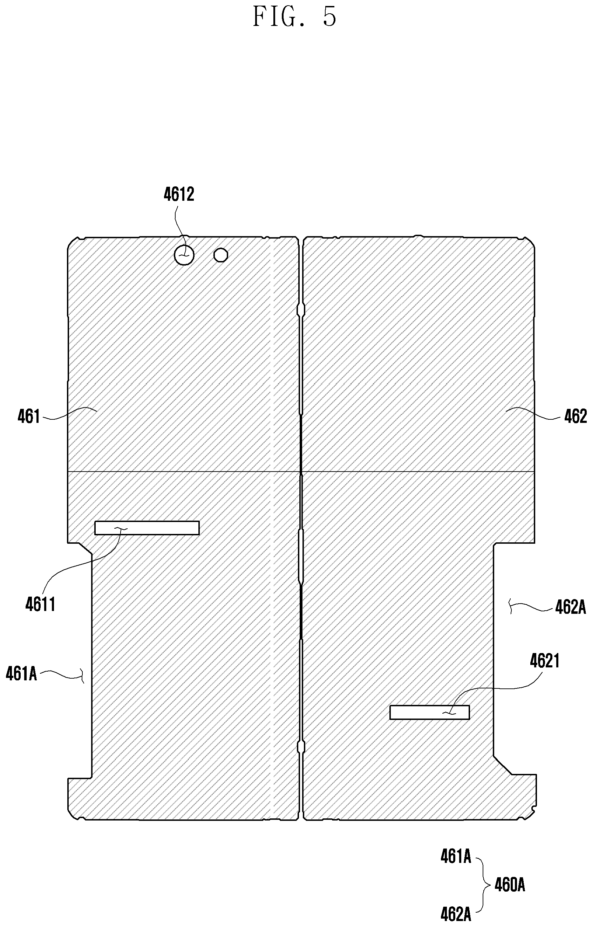

FIG. 5 is a constitutional diagram of reinforcing plates according to various embodiments of the disclosure. FIG. 6 is a view illustrating a rear structure of a flexible display according to various embodiments of the disclosure.

With reference to FIGS. 5 and 6, the electronic device (e.g., electronic device 200 of FIG. 3) may include a first reinforcing plate 461 corresponding to the first housing (e.g., first housing 210 of FIG. 1A) and a second reinforcing plate 462 corresponding to the second housing (e.g., second housing 220 of FIG. 1A). According to an embodiment, the first digitizer panel (e.g., first digitizer panel 471 of FIG. 4) may be disposed between the support plate (e.g., support plate 450 of FIG. 4) and the first reinforcing plate 461, and the first cable member 4711 of the first digitizer panel 471 may be electrically connected to the substrate (e.g., first substrate 271 of FIG. 3) disposed in the first space (e.g., first space 2101 of FIG. 1A) of the first housing (e.g., first housing 210 of FIG. 1A) through the first reinforcing plate 461. Accordingly, the first reinforcing plate 461 may include a first through-hole 4611 for being penetrated by the first cable member 4711. According to an embodiment, the second digitizer panel (e.g., second digitizer panel 472 of FIG. 4) may be disposed between the support plate (e.g., support plate 450 of FIG. 4) and the second reinforcing plate 462, and the second cable member 4721 of the second digitizer panel 472 may be electrically connected to the substrate (e.g., second substrate 272 of FIG. 3) disposed in the second space (e.g., second space 2201 of FIG. 1A) of the second housing (e.g., second housing 220 of FIG. 1A) through the second reinforcing plate 462. Accordingly, the second reinforcing plate 462 may include a second through-hole 4621 for being penetrated by the second cable member 4721. According to an embodiment, the first reinforcing plate 461 may include at least one hole 4612 for at least one electronic component (e.g., camera module or sensor module) disposed to be supported by the first support member (e.g., first support member 261 of FIG. 3). For example, the at least one electronic component may be disposed to correspond to the at least one hole 4612, and thus an external environment may be detected through the flexible display 230.

According to various embodiments, the electronic device (e.g., electronic device 200 of FIG. 3) may include a first waterproof structure WP1 disposed between the first reinforcing plate 461 and the first support member (e.g., first support member 261 of FIG. 3) of the first housing (e.g., first housing 210 of FIG. 3), and a second waterproof structure WP2 disposed between the second reinforcing plate 462 and the second support member (e.g., second support member 262 of FIG. 3) of the second housing (e.g., second housing 220 of FIG. 3). According to an embodiment, the first waterproof structure WP2 may include at least one first waterproof space 4811, 4812, and 4813 formed through the first waterproof member 481. According to an embodiment, the first waterproof member 481 may include at least one of a tape, adhesive, waterproof dispensing, silicone, waterproof rubber, and urethane. According to an embodiment, at least one first waterproof space 4811 may include a first waterproof space 4811 in a closed loop shape, a second waterproof space 4812 in a closed loop shape that is spaced apart from the first waterproof space 4811, and a third waterproof space 4813 in a closed loop shape that is spaced apart from the second waterproof space 4812. According to an embodiment, when viewing the first reinforcing plate 461 from above, the first through-hole 4611 may be disposed at a location that overlaps the first waterproof space 4811 at least partly. According to an embodiment, when viewing the first reinforcing plate 461 from above, the at least one hole 4612 may be disposed at a location that overlaps at least a part of the second waterproof space 4812. The third waterproof space 4813 may be disposed at a location that overlaps at least one electronic component (e.g., sensor module).

According to various embodiments, the second waterproof structure WP2 may include a fourth waterproof space 4821 in a closed loop shape formed through the (2-1)-th waterproof member 482, the (2-2)-th waterproof member 483, and the (2-3)-th waterproof member 484. According to an embodiment, when viewing the second reinforcing plate 462 from above, the second through-hole 4621 may be disposed at a location that overlaps at least a part of the fourth waterproof space 4821. According to an embodiment, the fourth waterproof space 4821 may be formed between the second reinforcing plate 462 and the second support member 262 through the (2-1)-th waterproof member 482 disposed to surround at least a part of the bending portion 432, the (2-2)-th waterproof member 483 disposed between the extension portion 4321 and the second support member 262, and the (2-3)-th waterproof member 484 connecting the (2-1)-th waterproof member 482 and the (2-2)-th waterproof member 483 with each other. According to an embodiment, if the (2-1)-th waterproof member 482 and the (2-2)-th waterproof member 483 are integrally formed with each other, moisture or foreign substances may enter through a gap formed by a height difference (gap) between the bending portion 432 and the second reinforcing plate 462. According to an embodiment, the (2-1)-th waterproof member 482 may be attached to the (2-2)-th waterproof member 483 in a separated state of being spaced apart from the above-described gap portion at a designated interval, and the gap portion including the corresponding interval may be seamlessly connected through the (2-3)-th waterproof member 484. According to an embodiment, the (2-3)-th waterproof member 484 may include cured in place gaskets (CIPG) (e.g., waterproof filler member) that includes a semi-solid or liquid material and has a property of being solidified by natural or external conditions (e.g., heat, ultraviolet rays, moisture, or pressure).

According to various embodiments, when viewing the second reinforcing plate 462 from above, the second through-hole 4621 may be disposed at a location that overlaps at least a part of the fourth waterproof space 4821. According to an embodiment, the flexible display 230 may include the third cable member 4323 extending from the flexible board 4322 of the bending portion 432. According to an embodiment, the third cable member 4323 may be electrically connected to the substrate (e.g., second substrate 272 of FIG. 3) disposed in the second space (e.g., second space 2201 of FIG. 1A) through the second support member 262. According to an embodiment, when viewing the second reinforcing plate 262 from above, an area in which the third cable member 4323 is disposed may be disposed in an area that overlaps at least a part of the fourth space 4821. Accordingly, since the second through-hole 4621 and the third cable member 4323 are located within the fourth waterproof space 4821 in the closed loop shape, the penetration of the moisture and the foreign substances can be prevented.

According to various embodiments, as illustrated in FIG. 5, the first reinforcing plate 461 and the second reinforcing plate 462 may include partially concavely formed portions. For convenience in explanation, this portion is called a removal area 460A. With reference to FIG. 5, the removal area 460A may be a part that is concavely formed from the outskirts of the first reinforcing plate 461 and the second reinforcing plate 462 toward the center of the first reinforcing plate 461 and the second reinforcing plate 462.

For example, the removal area 460A may be formed by removing (e.g., cutting) portions of the first reinforcing plate 461 and the second reinforcing plate 462, or the first reinforcing plate 461 and the second reinforcing plate 462 may be produced in the shape including the removal area 460A.

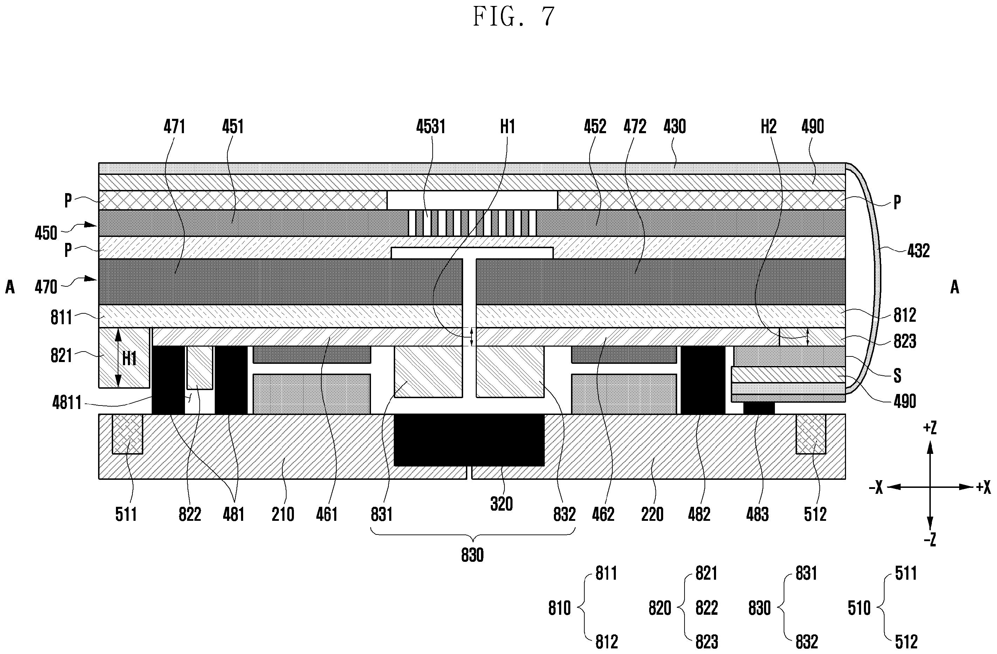

In various embodiments, the removal area 460A may be an area that corresponds to the location where a magnet member (e.g., magnet member 510 of FIG. 7) and shielding members 821 and 823 shielding the magnetic force of the magnet member are disposed. The magnet member may be disposed adjacent to a side portion of the electronic device so as to fix the folded state of the electronic device through the magnetic force. For example, a first magnet (e.g., first magnet 511 of FIG. 7) may be disposed in a first removal area 461A included in the first reinforcing plate 461, and a second magnet (e.g., second magnet 512 of FIG. 7) may be disposed in a second removal area 462A included in the second reinforcing plate 462. When the electronic device is in a folded state, and the first reinforcing plate 461 and the second reinforcing plate 462 face each other, the folded state of the electronic device may be fixed by the attraction force of the first magnet member and the second magnet member.

With reference to FIG. 6, shielding members 821 and 823 may be disposed in the removal area. The waterproof member 481 may be disposed between certain shielding members 821 and 822.

FIG. 7 is a schematic diagram of a display module illustrated in FIG. 6, in which the display module is cut along line X-X, and cross sections of the display module and surrounding constituent elements are schematized.

The electronic device according to various embodiments disclosed in the disclosure may include a shielding structure. While an electronic component operates, electromagnetic waves generated from an outside may cause a problem in the operation of the electronic component. In order for the electronic component included in the electronic device to be able to operate normally in the set operating range, the shielding structure may block electromagnetic interference (EMI), or may block interference caused by the magnetic field being generated from a magnetic object. The shielding structure may include a shielding member formed of various materials that can perform the EMI shielding function. The shielding member may include, for example, a material, such as metal, carbon, or conductive polymer, or a material made from a combination thereof. In an embodiment, the shielding member may be ARS. The shielding member may be made in various forms. For example, the shielding member may be made in the form of a sheet or a film.

The digitizer panel 470 that recognizes an input of a pen input device in an electromagnetic resonance (EMR) may have a deteriorated pen recognition performance due to an external magnetic field. Accordingly, the shielding member that can shield the magnetic field may be disposed between constituent elements that generate the magnetic field and the digitizer panel 470. For example, since the constituent elements, such as the magnet member 510, the hinge device 320, and the sensor member may generate the magnetic field, the shielding member may be disposed between such constituent elements and the digitizer panel 470.

In an embodiment, the electronic device may include the magnet member 510. The magnet member 510 may include a first magnet 511 disposed on the first housing 210 and a second magnet 512 disposed on the second housing 220. The first magnet 511 and the second magnet 512 may be disposed at portions corresponding to the first housing 210 and the second housing 220, respectively. The first housing 210 and the second housing 220 that face each other in the folded state of the electronic device may maintain a state where the first housing 210 and the second housing 220 are stuck together through the magnetic force (attraction force) of the first magnet 511 and the second magnet 512. This state may be maintained until an external force that exceeds the magnetic force is applied to the housings 210 and 220.

According to various embodiments, the shielding members 810, 820, 830, and 840 may include the first shielding member 810, the second shielding member 820, the third shielding member 830, and the fourth shielding member 840. The above-described shielding members are merely divided for convenience depending on the locations where the shielding members are disposed, but the numbers or the kinds of the shielding members are not divided. Further, at least one of the first shielding member 810 to the fourth shielding member 840 may be omitted, and the shielding members may be disposed even at other locations that are not described in this document.

The first shielding member 810, the second shielding member 820, and the third shielding member 830 may shield the constituent elements that generate the magnetic field at various locations. For example, the first shielding member 810 may be disposed on the rear surface of the digitizer panel 470. The first shielding member 810 may include, for example, magnetic metal powder (MMP). The second shielding member 820 may be disposed on the rear surface of the first shielding member 810 and the rear surfaces of the reinforcing plates 461 and 462. The third shielding member 830 may be disposed between the hinge device 320 and the display module 230. The fourth shielding member 840 may be disposed between the sensor member and the display module 230.

With reference to FIG. 7, the display module 230 may include a structure in which a plurality of layers are laminated. The layers of the display module 230 may include the display panel 430, the support member 450, the digitizer panel 470, and the reinforcing plates 461 and 462. The layers included in the display module 230 may be mutually fixed by adhesives P. Since the display module 230 illustrated in FIG. 7 is similar to the display module 230 illustrated in FIG. 4, the same or similar constituent elements will be described by using the same reference numbers, and the detailed description thereof will be omitted.

In an embodiment, a polymer film 490 may be disposed on the rear surface of the display panel 430. This polymer film 490 may be disposed even on the bending portion 432 extending to the rear surface of the display panel 430.

In an embodiment, the digitizer panel 470 may be disposed in a first direction (e.g., -Z direction of FIG. 7) with respect to the display panel 430. The digitizer panel 470 may include the first digitizer panel 471 disposed in the area corresponding to the first housing 210 and the second digitizer panel 472 disposed in the area corresponding to the second housing 220. As illustrated in FIG. 7, the first digitizer panel 471 and the second digitizer panel 472 may be separated from each other. In a certain embodiment, the first digitizer panel 471 and the second digitizer panel 472 may be integrally formed with each other.

In an embodiment, the reinforcing plates 461 and 462 may be disposed on the rear surface of the first shielding member 810. With reference to FIG. 7, the reinforcing plates 461 and 462 may include the first reinforcing plate 461 disposed on the rear surface of the (1-1)-th shielding member 811 and the second reinforcing plate 462 disposed on the rear surface of the (1-2)-th shielding member 812. The reinforcing plates 461 and 462 may be disposed on the rear surface of the first shielding member 810 in an area adjacent to the hinge device 320.

In an embodiment, the second shielding member 820 may include the (2-1)-th shielding member 821, the (2-2)-th shielding member 822, and the (2-3)-th shielding member 823. The (2-1)-th shielding member 821 and the (2-2)-th shielding member 822 may be the second shielding member 820 disposed in the area corresponding to the first housing 210, and the (2-3)-th shielding member 823 may be the second shielding member 820 disposed in the area corresponding to the second housing 220.

With reference to FIG. 7, the (2-1)-th shielding member 821 may be disposed on the rear surface of the (1-1)-th shielding member 811, and the (2-2)-th shielding member 822 may be disposed on the rear surface of the first reinforcing plate 461. In an embodiment, a part of the first reinforcing plate 461 may be removed or the size of the first reinforcing plate 461 may be adjusted so that the (2-1)-th shielding member 821 can be disposed on the rear surface of the (1-1)-th shielding member 811 (first removal area 461A of FIG. 5). The (2-1)-th shielding member 821 and the (2-2)-th shielding member 822 may be disposed to be spaced apart from each other. With reference to FIGS. 6 and 7, the first waterproof member 481 may be disposed between the (2-1)-th shielding member 821 and the (2-2)-th shielding member 822. The (2-1)-th shielding member 821 and the (2-2)-th shielding member 822 may be divided constituent elements, and may be disposed with the first waterproof member 481 interposed therebetween. In a certain embodiment, the (2-1)-th shielding member 821 and the (2-2)-th shielding member 822 may be integrally formed and then separated from each other through a separation method, such as cutting, and the first waterproof member 481 may be disposed between the (2-1)-th shielding member 821 and the (2-2)-th shielding member 822.

With reference to FIG. 7, the (2-1)-th shielding member 821 may be disposed between the first magnet 511 and the first digitizer panel 471. The (2-1)-th shielding member 821 and the (2-2)-th shielding member 822 may shield the magnetic field generated by the first magnet 511, and thus may reduce the influence of the magnetic field exerted on the operation of the digitizer panel 470. The first magnet 511 is a constituent element for maintaining the folded state of the first housing 210 and the second housing 220, and may be disposed on the outskirts of the first housing 210. Since the (2-1)-th shielding member 821 and the (2-2)-th shielding member 822 are constituent elements for shielding the first magnet 511, they may be disposed at locations adjacent to the first magnet 511.

With reference to FIGS. 6 and 7, the (2-2)-th shielding member 822 may be disposed in the first waterproof space 4811 formed to be surrounded by the first waterproof member 481. In contrast, the (2-1)-th shielding member 821 is disposed outside the first waterproof space 4811, and thus may be exposed to moisture. In an embodiment, the (2-1)-th shielding member 821 may include a waterproof structure capable of having moisture resistance. In contrast, the (2-2)-th shielding member 822 disposed inside the waterproof space may be composed of a non-waterproof structure.

With reference to FIG. 7, the (2-3)-th shielding member 823 may be disposed on the rear surface of the (1-2)-th shielding member 812. A part of the second reinforcing plate 462 may be removed, or the size of the second reinforcing plate 462 may be adjusted so that the (2-3)-th shielding member 823 can be disposed on the rear surface of the (1-2)-th shielding member 812 (second removal area 462A of FIG. 5). The (2-3)-th shielding member 823 may be located between the second magnet 512 and the second digitizer panel 472. The (2-3)-th shielding member 823 may shield the magnetic field being generated from the second magnet 512.

As illustrated in FIG. 7, the bending portion 432 connected to the display panel 430 may extend to the rear surface of the second reinforcing plate 462, and the bending portion 432 that extends to the rear surface of the second reinforcing plate 462 may face the second reinforcing plate 462 and the (2-3)-th shielding member 823. Between the bending portion 432, the second reinforcing plate 462, and the (2-3)-th shielding member 823, a gap compensation member S for filling the space between the bending portion 432, the second reinforcing plate 462, and the (2-3)-th shielding member 823 may be disposed. In case that a gap exists at a border portion of the second reinforcing plate 462 and the (2-3)-th shielding member 823, defect may occur on the bending portion 432 that faces the second reinforcing plate 462 and the (2-3)-th shielding member 823. In order to reduce the gap between the second reinforcing plate 462 and the (2-3)-th shielding member 823, the (2-3)-th shielding member 823 may be formed with a thickness H2 that is substantially the same as a thickness H1 of the second reinforcing plate 462. Here, the term "substantially the same" means that they are formed to have the same thickness, and may include that they are formed with somewhat different thicknesses due to various causes (e.g., process error).

In an embodiment, the third shielding member 830 may be disposed between the hinge device 320 and the display module 230. In an embodiment, the hinge device 320 may include a magnetic material, or may include a material that can be magnetized by a surrounding magnetic material. In case that the hinge device 320 includes the magnetic material, or is magnetized, a magnetic field is generated in the hinge device 320, and this magnetic field may exert an influence on the operation of the digitizer panel. The third shielding member 830 may shield the magnetic field of the hinge device 320.

With reference to FIGS. 6 and 7, the third shielding member 830 may be disposed on the rear surfaces of the reinforcing plates 461 and 462. The third shielding member 830 may include the (3-1)-th shielding member 831 disposed on the rear surface of the first reinforcing plate 461, and the (3-2)-th shielding member 832 disposed on the rear surface of the second reinforcing plate 462. As illustrated in FIG. 6, a plurality of the (3-1)-th shielding members 831 may be provided, and may be disposed to be spaced apart from each other. Further, a plurality of the (3-2)-th shielding members 832 may be provided, and may be disposed to be spaced apart from each other.

In an embodiment, the fourth shielding member 840 may be disposed between the sensor member (not illustrated) and the display module 230. In a certain embodiment, the electronic device may include the sensor member that senses the folded state or unfolded state of the electronic device. In an embodiment, the sensor member may include a hall sensor (not illustrated) and a magnet (not illustrated) disposed at a location corresponding to the hall sensor. For example, the hall sensor may be disposed on the first housing 210 or the second housing 220, and the magnet may be disposed on the first housing 210 or the second housing 220 on which the hall sensor is not disposed. If the hall sensor and the magnet are disposed on each of the first housing 210 and the second housing 220, which move relative to each other, the strength of the magnetic field that is recognized by the hall sensor may be changed depending on the relative distance between the magnet and the hall sensor, and by using this, the folded state or the unfolded state of the first housing 210 and the second housing 220 may be sensed. The fourth shielding member 840 may be disposed between at least one of the hall sensor and the magnet of the sensor member and the display module 230, and may shield the magnetic field being generated from the sensor member.

According to various embodiments, the waterproof members 481, 482, 483, and 484 may be disposed between the display module 230 and the housing, and may block the display module 330 and electrical objects connected to the display module 230 against external moisture.

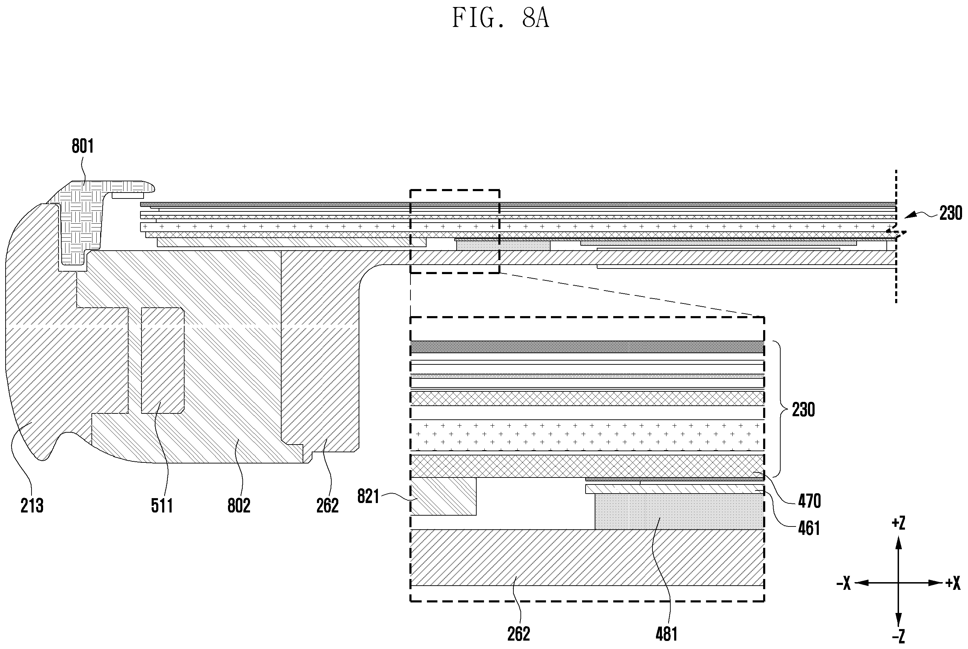

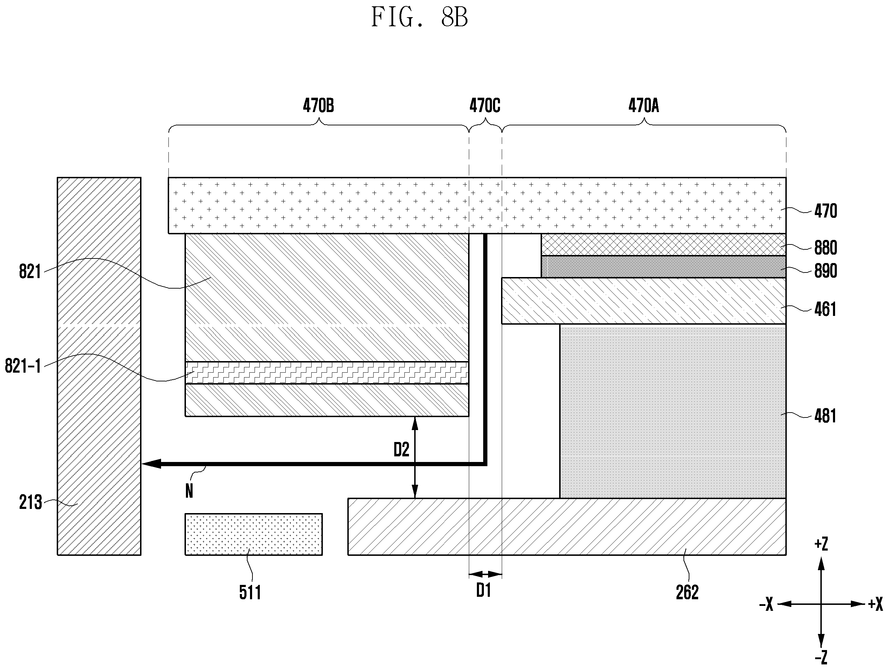

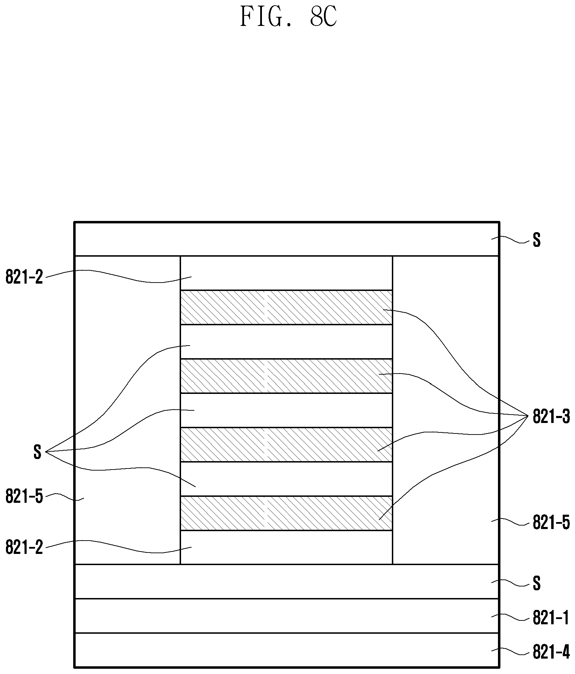

FIG. 8A is a cross-sectional view of an electronic device illustrated in FIG. 1A, cut along line B-B of FIG. 1A. FIG. 8B is a schematic diagram in which the drawing illustrated in FIG. 8A is schematized. FIG. 8C is a cross-sectional schematic diagram of a shielding member according to various embodiments disclosed in this document.

Since FIG. 8B is a schematic diagram in which the drawing illustrated in FIG. 8A is schematized for convenience in explanation, the sizes and locations of constituent elements are not limited to those illustrated in FIG. 8B.

Hereinafter, for convenience in explanation, explanation will be made with a focus on the digitizer panel (e.g., first digitizer panel 471 of FIG. 4) disposed on the first housing (e.g., first housing 210 of FIG. 3), the first reinforcing plate (e.g., first reinforcing plate 461 of FIG. 7) that supports the digitizer panel on the first housing, and their surrounding constituent elements. A part that is described in various embodiments disclosed in this document is related to a removal area (first removal area 461A of FIG. 5) from which a part of the first reinforcing plate 461 that supports the digitizer panel 470 is removed, and as described above through FIG. 5, since the removal area 461A exists even on the second reinforcing plate (e.g., second reinforcing plate 462 of FIG. 7), the contents to be described hereinafter can be applied even to the removal area of the second reinforcing plate 462 and the surrounding constituent elements in the same manner. For example, it may be understood that the first reinforcing plate 461 to be described hereinafter may be replaced by the second reinforcing plate 462.

Hereinafter, explanation will be made in a state where the first reinforcing plate 461 of FIG. 7 is called the reinforcing plate 461, the first magnet member 511 is called the magnetic member 511, the (2-1)-th shielding member 821 is called the shielding member 821, the first waterproof member 481 is called the waterproof member 481, and the first side member 221 is called the side member 221.

With reference to FIG. 8A, the display module 230 according to various embodiments disclosed in this document may include a plurality of layers. For example, the display module 230 may include the constituent elements as described above with reference to FIG. 4. The laminated structure included in the display module 230 may refer to FIG. 4.

In an embodiment, the shielding member 821 and the reinforcing plate 461 may be disposed on the rear surface of the digitizer panel 470. In the following description, to help understanding of the disclosure, the digitizer panel 470 is divided into a plurality of areas. Each of the areas of the digitizer panel 470 is not an actually visually or physically divided area, and may be understood as a divided area depending on the location of the constituent element disposed to face the digitizer panel 470 or to be adjacent to the digitizer panel 470.

With reference to FIG. 8B, the first area 470A of the digitizer panel 470 may be an area corresponding to a part where the reinforcing plate 461 is disposed. The second area 470B of the digitizer panel 470 may be an area corresponding to a part where the magnet member 511 and the shielding member 821 for shielding the magnetic force of the magnet member 511 are disposed. Further, the second area 470B of the digitizer panel 470 may be an area that is adjacent to the side member of the electronic device. The third area 470C of the digitizer panel 470 may be between the first area 470A and the second area 470B. The removal area 461A as described above through FIG. 5 is an area where the reinforcing plate 461 does not exist, and may correspond to an area including the second area 470B and the third area 470C.

A stylus pen recognition operation by the digitizer panel 470 will be briefly described as follows. By the magnetic field that is generated by current flowing to the digitizer panel 470, abandoned electromotive force may be generated in the stylus pen that approaches the digitizer panel 470. The stylus pen may generate a specific frequency signal through this current, and the digitizer panel 470 may perform the pen recognition operation by identifying the location where the signal is sensed. On the other hand, the conductive member disposed on the rear surface of the digitizer panel 470 may be used as a ground for the operation of the digitizer panel 470. For example, the reinforcing plate 461 formed of a conductive material or the conductive sheet 880 disposed between the reinforcing plate 461 and the digitizer panel 470 and formed of a conductive material may be used as the ground for the operation of the digitizer panel 470.

If the magnetic field that is generated by the digitizer panel 470 is changed by a magnetic component (e.g., magnet member 511) adjacent to the digitizer panel 470, an error may occur in an input location of the stylus pen that is recognized by the digitizer panel 470. Further, if the magnetic field around the digitizer panel 470 is changed by the digitizer panel 470 or the stylus pen, an eddy current may be produced in the adjacent conductive material, and due to this eddy current, a recognition error may occur in the digitizer panel 470. In order to solve the problem caused by the magnetic component, the shielding member 821 for shielding the magnetic force of the magnetic component may be disposed, and in order to prevent the eddy current from being produced, the digitizer panel 470 may include a magnetic metal powder (MMP) layer (e.g., first shielding member 810 of FIG. 7).

In spite of the above-described structure to prevent the malfunction of the digitizer panel 470, the MMP included in the digitizer panel 470 may be saturated by the magnetic force of the magnetic component adjacent to the digitizer panel 470. If the MMP included in the digitizer panel 470 is saturated, the eddy current may be produced in the conductive member disposed around the digitizer panel 470. Since the eddy current is produced in the conductive member disposed around the digitizer panel 470 by the saturated MMP, it may be necessary to remove the conductive member between the magnetic component (e.g., magnet member 511) having the magnetic force over a predetermined level and the digitizer panel 470 including the MMP. In case that the conductive member does not exist between the magnetic component and the MMP, the eddy current is not produced even if the MMP is saturated, and thus the digitizer panel 470 can operate normally.

As illustrated in FIG. 8B, the reinforcing plate 461 and the conductive sheet 880, which are conductive members, may be located only in a part corresponding to the first area 470A of the digitizer panel 470, and may not be disposed in the second area 470B corresponding to the part where the magnet member 511 and the shielding member 821 are disposed.

The reinforcing plate 461 and the conductive sheet 880, which are conductive members, may be the ground of the digitizer panel 470. In the second area 470B and the third area 470C that is an area between the first area 470A and the second area 470B, the reinforcing plate 461 or the conductive sheet 880 may not be disposed. The current for the operation of the digitizer panel 470 may be partially abandoned in the second area 470B and the third area 470C, in which the reinforcing plate 461 or the conductive sheet 880 is not disposed, and may act as noise N on the adjacent electronic component.

In an embodiment, the shielding member 821 may include a metal sheet 821-1 for shielding an electrical signal. Accordingly, the current abandoned into the second area 470B in which the shielding member 821 is disposed may be blocked by the metal sheet 821-1. However, since the area between the first area 470A and the second area 470B is not hidden by the conductive member and is exposed, the current of the digitizer panel 470 may be abandoned therein.

In the first area 470A, the reinforcing plate 461, the conductive sheet 880, and an adhesive member 890 for attaching the conductive sheet 880 to the digitizer panel 470 may be disposed, and in the second area 470B, the shielding member 821 may be disposed. Since a free space (e.g., attachment tolerance) D1 for adjacently disposing different constituent elements to each other is required, the digitizer panel 470 may be exposed in the third area 470C. Further, in case of extending and disposing the reinforcing plate 461 or the shielding member 821 up to the third area 470C, interference may occur between the reinforcing plate 461 and the shielding member 821 in the folding or unfolding process of the electronic device, and thus the surface quality (e.g., flatness) of the digitizer panel 470 may become defective. Accordingly, there may be a limit in extending and disposing the reinforcing plate 461 or the shielding member 821 up to the third area 470C.

In an embodiment, the support member 262 may be disposed in the first direction (e.g., -Z direction of FIG. 8B) with respect to the reinforcing plate 461. The support member 261 may be a mechanical part that generally supports various electronic components disposed on the first housing 210. The support member 261 may be integrally formed with the first housing 210, may be formed separately from the first housing 210, or may be formed of a material that is the same as or different from the material of the first housing 210. As illustrated in FIG. 8B, the waterproof member 481 may be disposed between the support member 262 and the reinforcing plate 461. The waterproof member 481 may attach the reinforcing plate 461 to the support member 262. Further, the waterproof member 481 may seal between the reinforce plate 461 and the support member 262, and may block the entrance of external moisture or foreign substances between the reinforcing plate 461 and the support member 262. As illustrated in FIG. 8B, the support member 262 and the shielding member 821 may be spaced apart (D2) from each other. This may be in consideration of the surface quality (e.g., flatness) of the digitizer panel 470.

**In** an embodiment, the side member 213 of the electronic device adjacent to the second area 470B of the digitizer panel 470 may be used as an antenna. The side member 213 may be disposed on the side surface of the electronic device (-X direction based on FIG. 8A). The side member 213 may be formed integrally with or separately from the first housing 210. The side member 213 may be formed of the same material as or different material from the material of the first housing 210. Since the side member 213 is formed of the conductive member, and is electrically connected to a communication module (not illustrated) of the electronic device, the side member 213 may be used as an antenna (e.g., antenna radiator) for transmitting or receiving a communication signal. The current N abandoned to the third area 470C of the digitizer panel 470 may be abandoned to the side member 213 through the gap space between the support member 262 and the shielding member 821. Due to this abandoned current N, a parasitic current is produced in the side member 213, and may exert an influence on the antenna performance of the side member 213. For example, deviation of the antenna performance may occur between the same products, and the deviation may occur in a specific frequency.

**In** various embodiments, the side housing 801 may be disposed on the front surface (surface directed in +Z direction of FIG. 8A) of the electronic device. The side housing 801 may be disposed on the side surface of the electronic device in the front surface direction of the electronic device. A part of the display module 230 may be hidden by the side housing 801. For example, when viewing the electronic device from the front surface of the electronic device, parts of the side housing 801 and the display module 230 may overlap each other.

As illustrated in FIG. 8A, an auxiliary mechanical part 802 may be disposed between the side member 213 and the support member 262. The auxiliary mechanical part 802 may be formed integrally with or separately from the first housing 210. The auxiliary mechanical part 802 may be formed of the same material as or a different material from the material of the first housing 210.

With reference to FIG. 8C, the shielding member 821 may include a plurality of layers formed of different materials. For example, the shielding member 821 may include cover layers 821-2 and 821-4, a metal sheet 821-1, adhesive layers S, shielding layers 821-3, and a gap compensation layer 821-5. The adhesive layers S may be disposed between the plurality of layers so as to glue together the plurality of layers included in the shielding member 821. The cover layers 821-2 and 821-4 may be a base for laminating the layers formed of various materials on the shielding member 821. The cover layers 821-2 and 821-4 may include the first cover layer 821-2 formed of a transparent material and the second cover layer 821-4 formed of an opaque material. The shielding layers 821-3 may be formed of a material that can shield the magnetic force. The shielding layers 821-3 may include, for example, ARS. The shielding layers 821-3 may be formed with a thickness of about 26 µm. In order for the shielding member 821 to reduce the influence of the magnetic component, it may be required to secure the thickness of the shielding layers 821-3 that perform the function of shielding the magnetic force in the shielding member 821 above a predetermined level. In case that the shielding member 821 includes the shielding layers 821-3 (e.g., four layers) having the thickness of about 26 µm, the sum of the thicknesses of the shielding layers 821-3 included in the shielding member 821 may be about 104 µm. Since different materials are laminated on the gap compensation layer 821-5, it may be a layer for removing an empty space of the gap of the shielding member 821. The cross-section structure of the shielding member 821 is merely exemplary, and the shielding member 821 may be composed of other various structures.

Hereinafter, various embodiments to solve the above problems will be described. In the following description, detailed description of the constituent elements which are the same as or similar to the above-described constituent elements will be omitted.

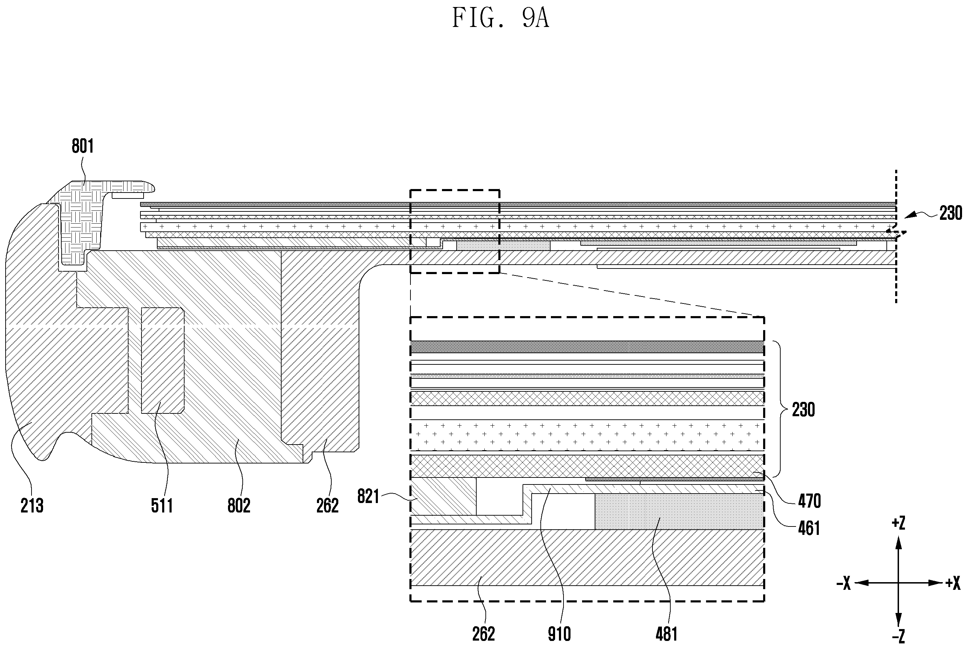

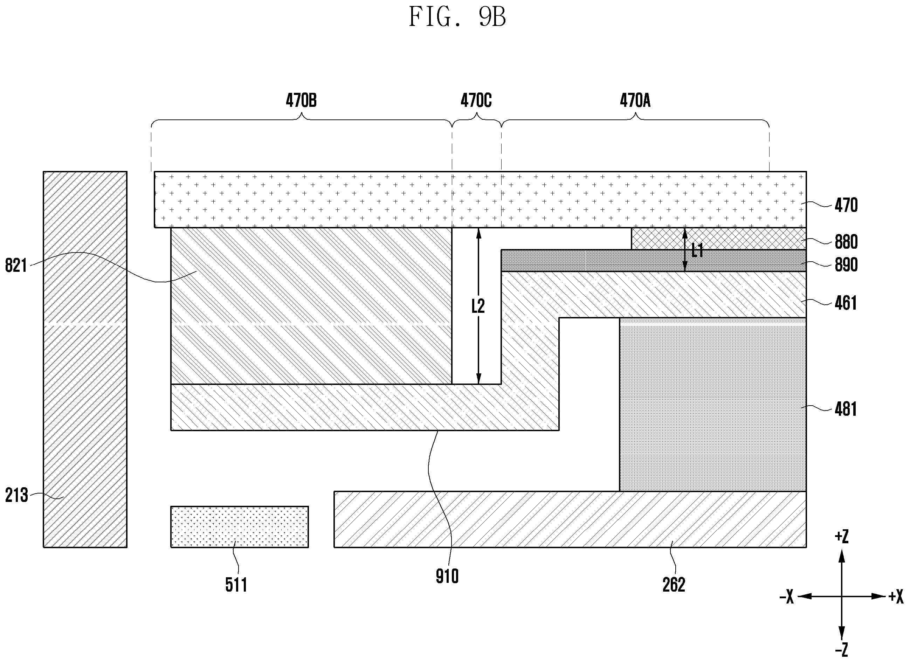

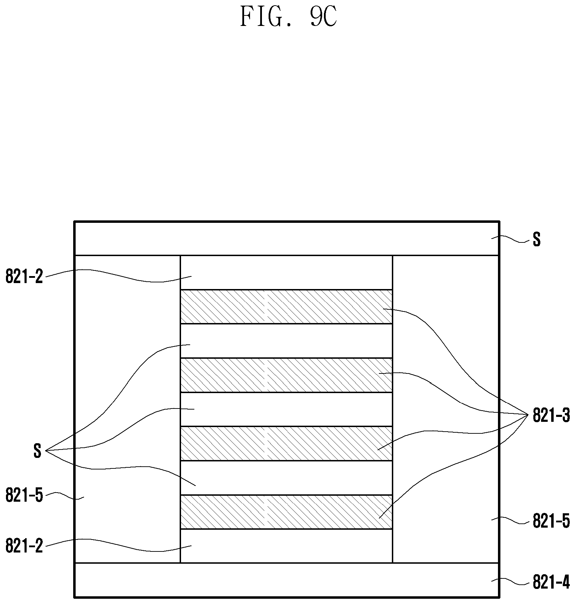

FIGS. 9A and 9B are views illustrating an embodiment of an electronic device disclosed in this document. FIG. 9A is a cross-sectional view of an electronic device illustrated in FIG. 1A, cut along line B-B of FIG. 1A. FIG. 9B is a schematic diagram in which the drawing illustrated in FIG. 9A is schematized. FIG. 9C is a cross-sectional schematic diagram of a shielding member according to various embodiments disclosed in this document.

According to various embodiments, the electronic device may include a middle member 910. The middle member 910 may be formed of a conductive material. The middle member 910 may be located to correspond to the second area 470A and the third area 470C of the digitizer panel 470, and may be electrically connected to the reinforcing plate 461 disposed in the first area 470A of the digitizer panel 470. Since the second area 470B and the third area 470C are hidden by the middle member 910, the problem in that the current by the operation of the digitizer panel 470 is abandoned in the second area 470B and the third area 470C of the digitizer panel 470 can be solved. The current abandoned in the second area 470B and the third area 470C may flow to the middle member 910 that is electrically connected to the reinforcing plate 461 that functions as the ground (or that is connected to the ground). Due to this, the current abandonment problem can be reduced. Further, the distance L2 between the middle member 910 located in the second area 470B and the third area 470C and the digitizer panel 470 may be larger than the distance L1 between the reinforcing plate 461 located in the first area 470A and the digitizer panel 470. Since the distance between the digitizer panel 470 and the middle member 910 is long even if the MMP included in the digitizer panel 470 is saturated by the magnet member 511, the eddy current produced by the middle member 910 due to the MMP saturation may exert little influence on the operation of the digitizer panel 470. Accordingly, the digitizer panel 470 may operate with the designated quality.

In various embodiments disclosed in this document, since even if the middle member 910 is disposed, the interval D2 between the middle member 910 and the support member 262 can be secured, and the interval D1 between the middle member 910 and the support member 262 can be secured, the tolerance for disposition between different constituent elements can be secured, and thus the surface quality of the digitizer panel 470 can be maintained at an equivalent level to that before the middle member 910 is disposed.

With reference to FIGS. 9A and 9B, in an embodiment, the middle member 910 may be integrally formed with the reinforcing plate 461. The middle member 910 may be formed of a flexible material that can be transformed. The middle member 910 may extend from the reinforcing plate 461, and a partial section thereof may be bent. Accordingly, the middle member 910 disposed in the second area 470B and the third area 470C may be located farther from the digitizer panel 470 than the reinforcing plate 461 disposed in the first area 470A. The middle member 910 may be formed to extend so that the middle member 910 can be disposed on the rear surface of the shielding member 821 disposed in the second area 470B. Since the middle member 910 that is integrally formed with the reinforcing plate 461 is located in the second area 470B and the third area 470C of the digitizer panel 470, the current abandoned in the second area 470B and the third area 470C may be blocked by the middle member 910.

With reference to FIG. 9C, the shielding member 821 may include a plurality of layers formed of different materials. For example, the shielding member 821 may include cover layers 821-2 and 821-4, adhesive layers S, shielding layers 821-3, and a gap compensation layer 821-5. The cover layers 821-2 and 821-4 may include the first cover layer 821-2 formed of a transparent material and the second cover layer 821-4 formed of an opaque material. The shielding layers 821-3 may be formed of a material that can shield the magnetic force. The shielding layers 821-3 may include, for example, ARS. Since the middle member 910 is disposed in the second area 470B of the digitizer panel 470 on which the shielding member 821 is disposed, in the disposition as in FIGS. 9A and 9B, the shielding member 821 may not include a metal sheet (e.g., metal sheet 821-1 of FIG. 8C), being different from that illustrated in FIG. 8C. Even if the middle member 910 is disposed, the thickness of the shielding layer 821-3 included in the shielding member 821 may be maintained at an equivalent level to that of the shielding member 821 illustrated in FIG. 8C. For example, the shielding member 821 may include shielding layers 821-3 (about four layers) with a thickness of about 26 µm, and the thickness of the shielding layers 821-3 included in the shielding member 821 may be about 104 µm, which is the equivalent level to the level of the shielding member 821 illustrated in FIG. 8C. Accordingly, the shielding member 821 may maintain the thickness for shielding the magnetic force of the magnet member. The gap compensation layer 821-5 may be a layer for removing an empty space of the gap of the shielding member 821 which may occur through the lamination of the different materials.

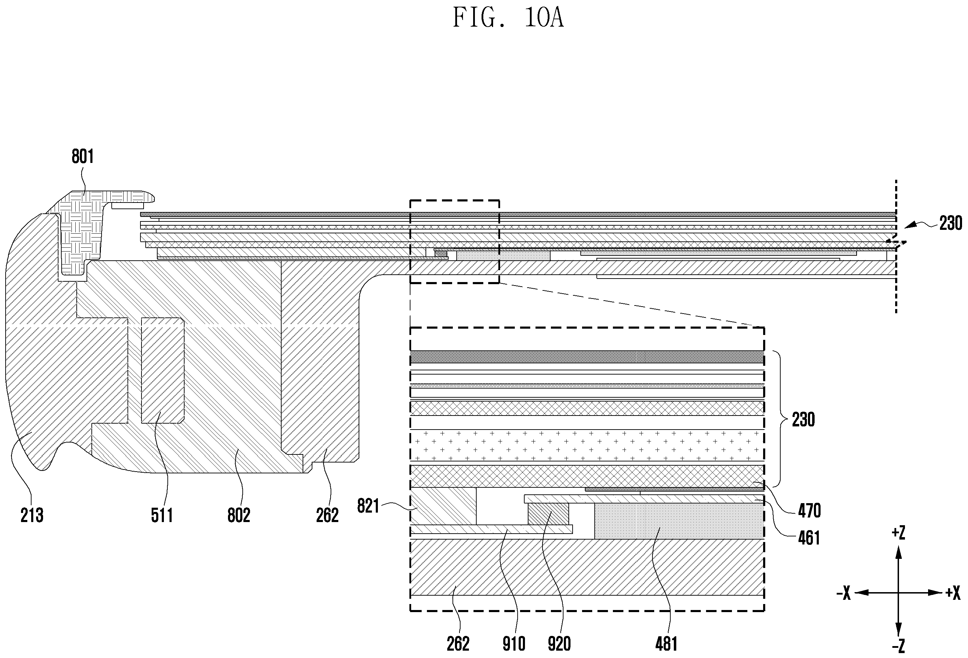

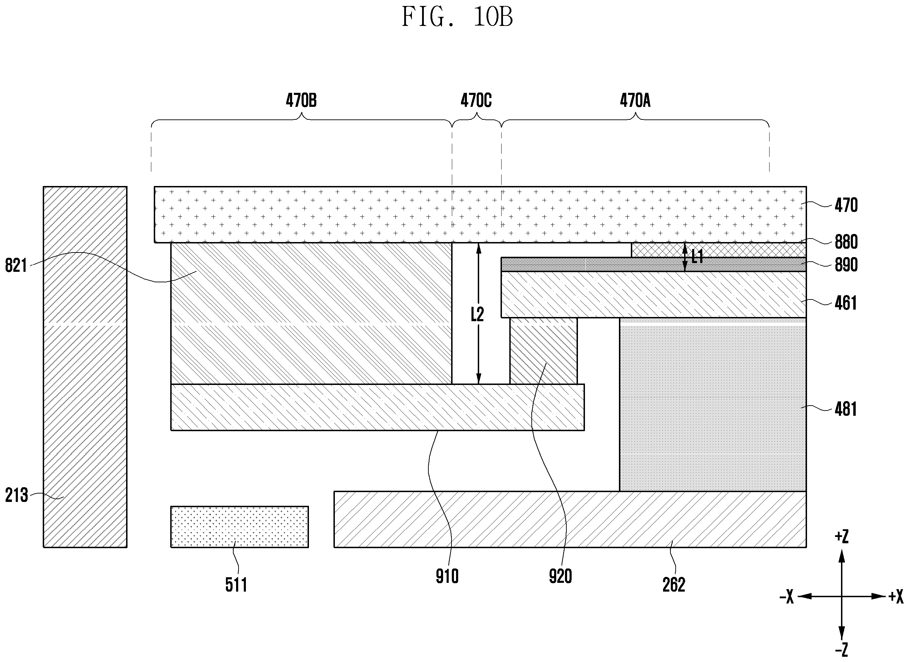

FIGS. 10A and 10B are views illustrating an embodiment of an electronic device disclosed in this document. FIG. 10A is a cross-sectional view of an electronic device illustrated in FIG. 1A, cut along line B-B of FIG. 1A. FIG. 10B is a schematic diagram in which the drawing illustrated in FIG. 10A is schematized.

With reference to FIG. 10B, in an embodiment, the middle member 910 may be formed separately from the reinforcing plate 461. As illustrated in FIG. 10B, the middle member 910 may be disposed at a location corresponding to the second area 470B and the third area 470C. The middle member 910 may be disposed on the rear surface of the shielding member 821 disposed in the second area 470B. The middle member 910 may be electrically connected to the reinforcing plate 461 by a conductive connection member 920 disposed between the middle member 910 and the reinforcing plate 461. The conductive connection member 920 may be formed of a member having adhesiveness so as to mutually glue the reinforcing plate 461 and the middle member 910. Since the middle member 910 is located in the second area 470B and the third area 470C of the digitizer panel 470, and is electrically connected to the reinforcing plate 461, the current abandoned to the second area 470B and the third area 470C may be blocked by the middle member 910.

The distance L2 between the digitizer panel 470 and the middle member 910 in the second area 470B and the third area 470C may be larger than the distance L1 between the digitizer panel 470 and the reinforcing plate 461 in the first area 470A.

In an embodiment illustrated in FIGS. 10A and 10B, the shielding member 821 may have the structure that is the same as or similar to that illustrated in FIGS. 9A and 9B.

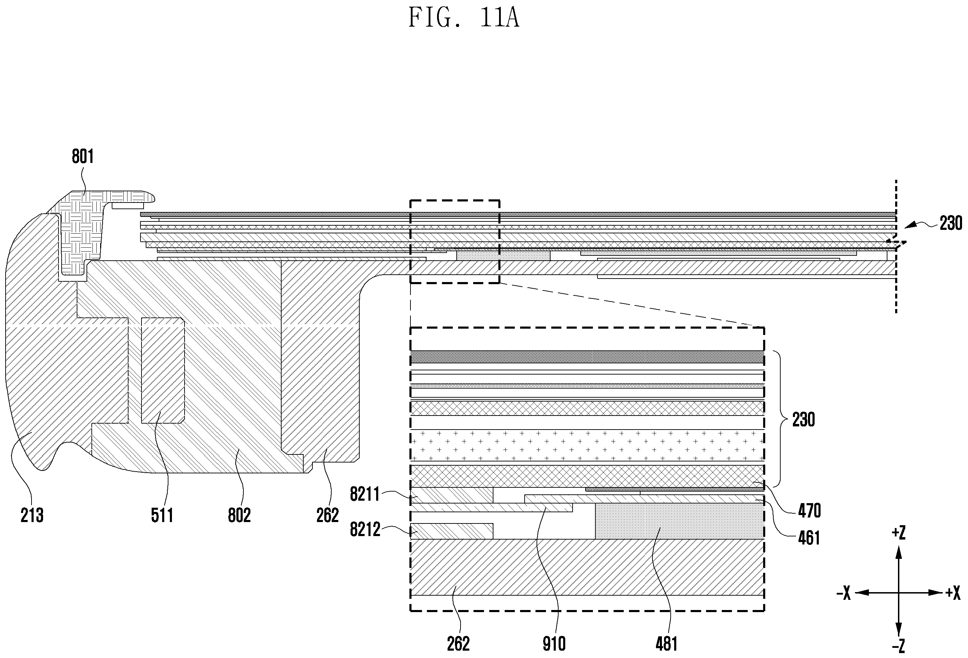

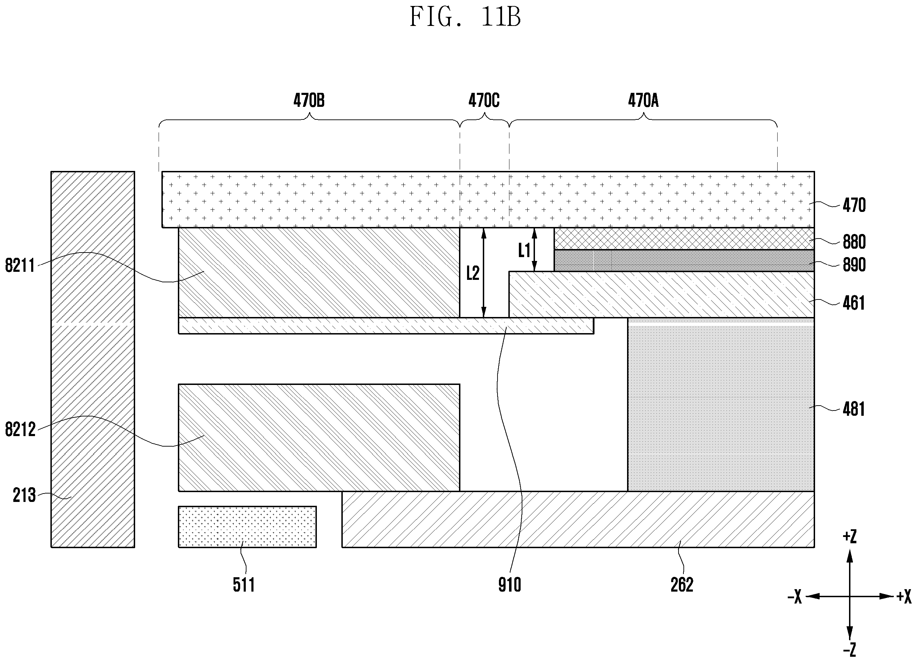

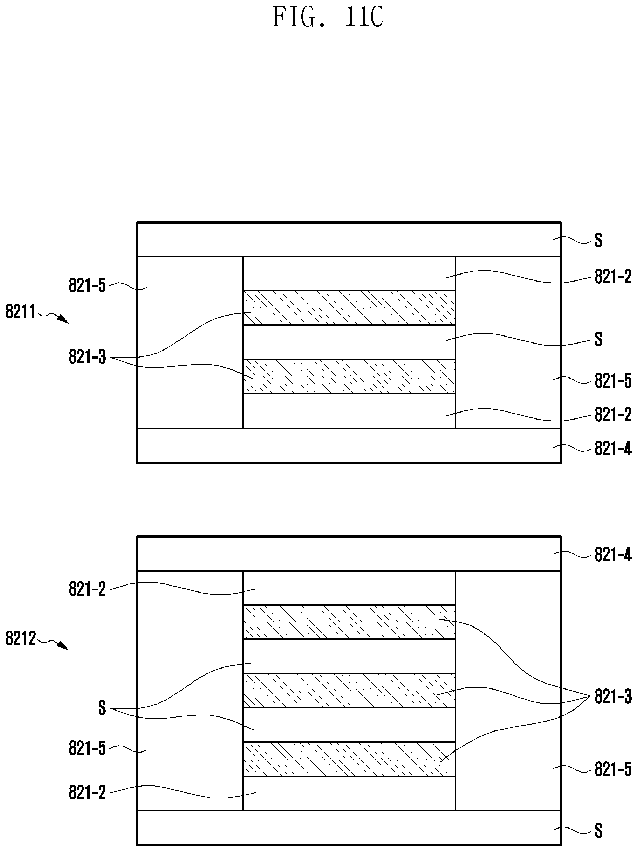

FIGS. 11A and 11B are views illustrating an embodiment of an electronic device disclosed in this document. FIG. 11A is a cross-sectional view of an electronic device illustrated in FIG. 1A, cut along line B-B of FIG. 1A. FIG. 11B is a schematic diagram in which the drawing illustrated in FIG. 11A is schematized. FIG. 11C is a cross-sectional schematic diagram of a shielding member according to various embodiments disclosed in this document.

With reference to FIG. 11B, in an embodiment, the shielding member 821 may include a first shielding member 8211 and a second shielding member 8212. The first shielding member 8211 may be disposed to come in close contact with the digitizer panel 470 in the second area 470B. The second shielding member 8212 may be disposed to be spaced apart in the first direction (e.g., -Z direction of FIG. 11B) from the first shielding member 8211. The middle member 910 may be disposed between the first shielding member 8211 and the second shielding member 8212, and may be attached and electrically connected to the reinforcing plate 461 disposed in the first area 470A through the third area 470C. With reference to FIG. 11B, the middle member 910 may be disposed on the rear surface of the first shielding member 8211. Since the middle member 910 is located in the second area 470B and the third area 470C of the digitizer panel 470, and is electrically connected to the reinforcing plate 461, the current abandoned in the second area 470B and the third area 470C may be blocked by the middle member 910.

The distance L2 between the digitizer panel 470 and the middle member 910 in the second area 470B and the third area 470C may be larger than the distance L1 between the digitizer panel 470 and the reinforcing plate 461 in the first area 470A.

With reference to FIG. 11C, in an embodiment, the first shielding member 8211 may include cover layers 821-2 and 821-4, shielding layers 821-3, and an adhesive layer S. The adhesive layer S may be disposed between a plurality of layers so as to glue together the plurality of layers included in the shielding member 821. The cover layers 821-2 and 821-4 may be a base for laminating the layers formed of various materials on the shielding member 821. The cover layers 821-2 and 821-4 may include the first cover layer 821-2 formed of a transparent material and the second cover layer 821-4 formed of an opaque material. The shielding layers 821-3 may be formed of a material that can shield the magnetic force. The shielding layers 821-3 may include, for example, ARS. The first shielding member 8211 may include, for example, shielding layers 821-3 (e.g., two layers) having a thickness of about 18 µm. In an embodiment, the second shielding member 8212 may include the cover layers 821-2 and 821-4, shielding layers 821-3, and adhesive layers S. The adhesive layers S may be disposed between a plurality of layers so as to glue together the plurality of layers included in the shielding member 821. The cover layers 821-2 and 821-4 may be a base for laminating the layers formed of various materials on the shielding member 821. The shielding layers 821-3 may be formed of a material that can shield the magnetic force. The second shielding member may include, for example, shielding layers 821-3 (e.g., three layers) having a thickness of about 22 µm. The thickness of the shielding layer 821-3 included in the first shielding member 8211 is about 36 µm, and the thickness of the shielding layer 821-3 included in the second shielding member 8212 may be about 66 µm. The sum of the thicknesses of the shielding layers 821-3 included in the second shielding member 8212 may be about 102 µm. This may be similar to the sum (about 104 µm) of the thicknesses of the shielding layers 821-3 of the shielding member 821 illustrated in FIG. 9C. Accordingly, even if the structure illustrated in FIGS. 11A and 11B is used, it is possible to maintain the thickness of the shielding layer 821-3 at an equivalent level to the level of the shielding layer 821-3 of the shielding member 821 to which the structure illustrated in FIGS. 9A and 9B is applied. Since different materials are laminated on the gap compensation layer 821-5 of the first shielding member 8211 and the second shielding member 8212, the gap compensation layer 821-5 may be a layer for removing an empty space of the gap of the shielding member 821 that may occur.

In an embodiment, the middle member 910 may be integrally formed with the metal sheet 821-1 illustrated in FIG. 9C, and may extend to cross the third area 470C.

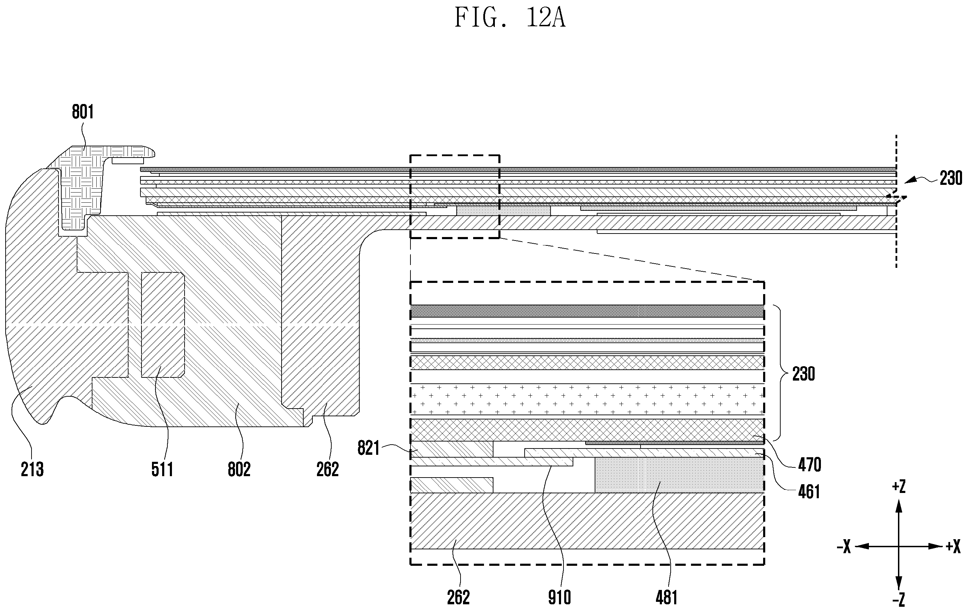

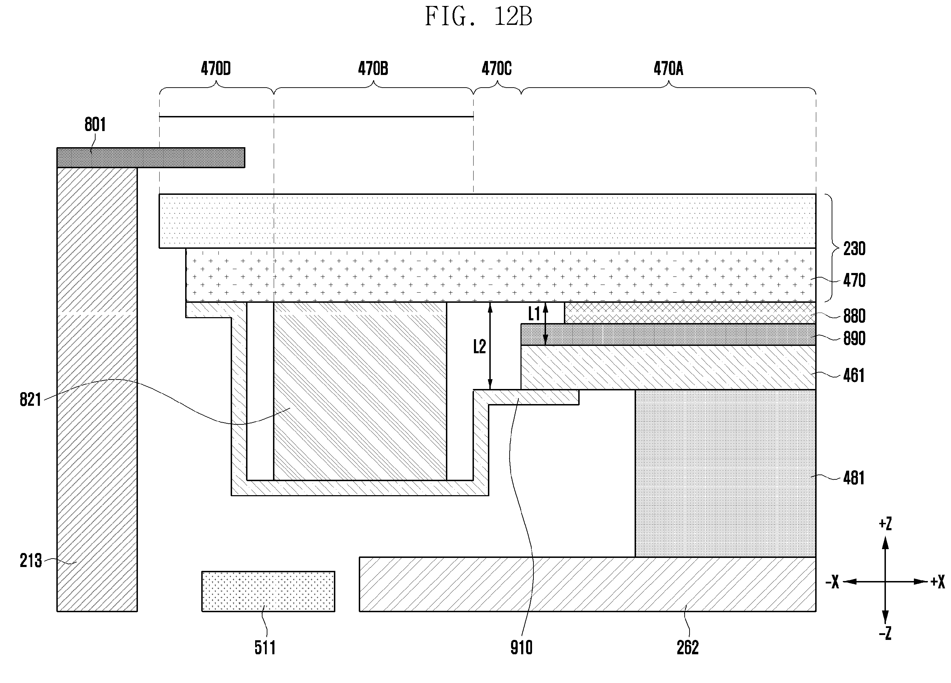

FIGS. 12A and 12B are views illustrating an embodiment of an electronic device disclosed in this document. FIG. 12A is a cross-sectional view of an electronic device illustrated in FIG. 1A, cut along line B-B of FIG. 1A. FIG. 12B is a schematic diagram in which the drawing illustrated in FIG. 12A is schematized.

With reference to FIG. 12B, in an embodiment, the digitizer panel 470 may further include a fourth area 470D. The fourth area 470D is an area that is more adjacent to the side member 213 than the second area 470B, and may be understood as the outermost area of the digitizer panel 470. Since the shielding member 821 is disposed in the second area 470B of the digitizer panel 470, the shielding member 821 may not be disposed in the fourth area 470D. At least a part of the fourth area 470D may overlap the side housing 801 disposed on the outskirts of the front surface of the electronic device. When viewing the electronic device from the front surface thereof (e.g., +Z direction of FIG. 12B), the side housing 801 and the fourth area 470D of the digitizer panel 470 may partially overlap each other. Although the fourth area 470D that overlaps the side housing 801 may be an area that the stylus pen is actually unable to approach, the current for the operation of the digitizer panel 470 may be transferred even to the fourth area 470D. Accordingly, the current may be abandoned through the fourth area 470D. The current abandoned in the fourth area 470D may act as a noise on the side member 213 that is adjacent to the fourth area 470D and functions as an antenna. The middle member 910 may have one end that is electrically connected to the reinforcing plate 461 disposed in the first area 470A, may be formed to extend up to the fourth area 470D through the third area 470C and the second area 470B, and may be disposed on the rear surface of the digitizer panel 470 in the fourth area 470D. Since the middle member 910 is located in the second area 470B, the third area 470C, and the fourth area 470D of the digitizer panel 470, and is electrically connected to the reinforcing plate 461, the current abandoned to the second area 470B, the third area 470C, and the fourth area 470D may be blocked by the middle member 910.

In an embodiment illustrated in FIGS. 10A and 10B, the shielding member 821 may have the structure (refer to FIG. 9C) that is the same as or similar to the structure as illustrated in FIGS. 9A and 9B.

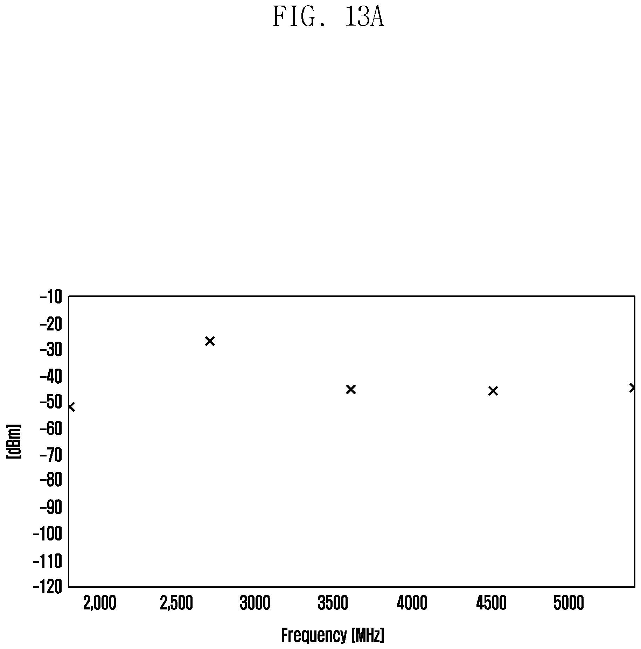

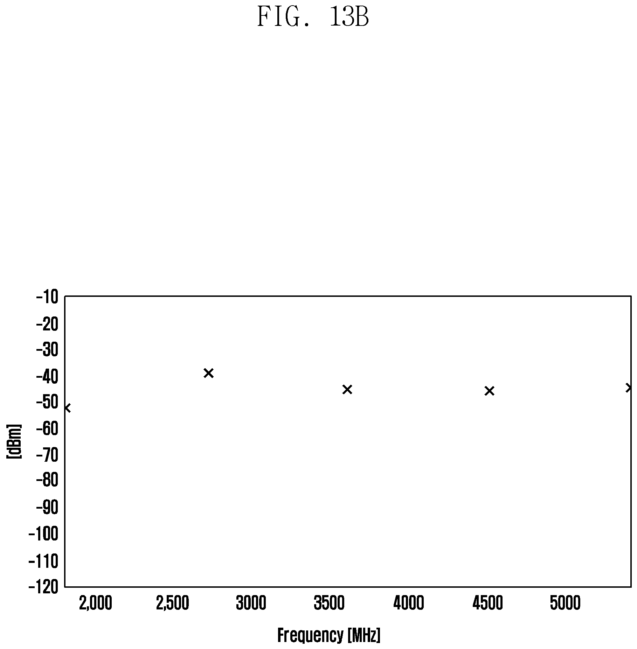

FIGS. 13A and 13B are diagrams capable of identifying an antenna radiation deviation of an electronic device according to various embodiments disclosed in this document.

In explaining FIGS. 13A and 13B, the constituent elements that are the same as or similar to the above-described constituent elements will be described by using the same reference numbers.

An antenna included in the electronic device may transmit or receive various frequency band signals. FIGS. 13A and 13B are graphs identifying a difference in antenna radiation performance in different frequency bands.

FIG. 13A represents the result of experimenting antenna radiation deviation in different frequencies in an electronic device including a structure in which the third area 470C of the digitizer panel 470 is in an exposed state (hereinafter, called "first embodiment"). FIG. 13B represents the result of experimenting antenna radiation deviation in different frequencies in an electronic device including a structure in which the third area 470C of the digitizer panel 470 is in a shielded state by the middle member 910 (hereinafter, called "second embodiment"). As described above through the drawings, the second embodiment may be understood as an electronic device having a structure in which the third area 470C of the digitizer panel 470 is hidden by the middle member 910.

In comparison of FIGS. 13A and 13B with each other, it can be identified that the antenna radiation deviation according to the frequency in the second embodiment is better than that in the first embodiment. In comparison of the antenna radiation performances in the frequency band of 2500 MHz, it can be identified that the difference in radiation performance in the second embodiment is relatively smaller than that in the first embodiment as compared with other frequency bands.

As described above, by shielding the third area 470C of the digitizer panel 470 with the middle member 910, the antenna radiation deviation according to the frequency can be reduced, thereby improving the radiation performance.

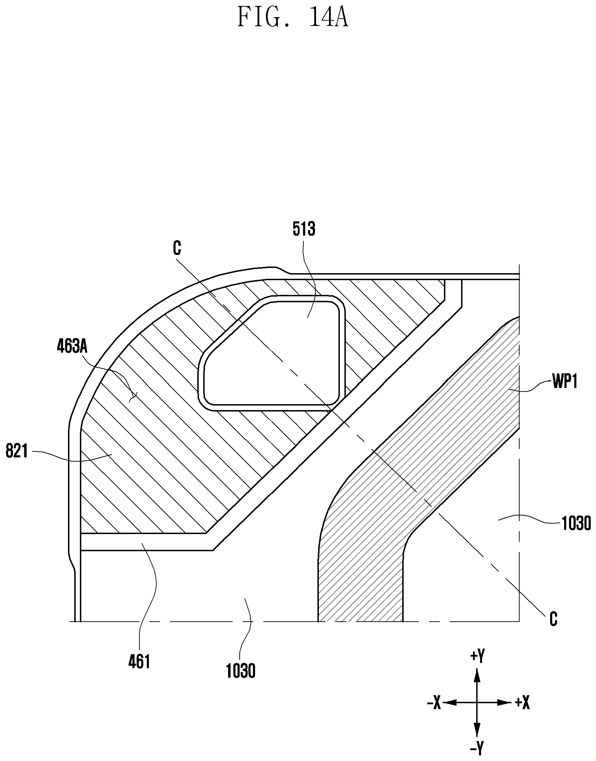

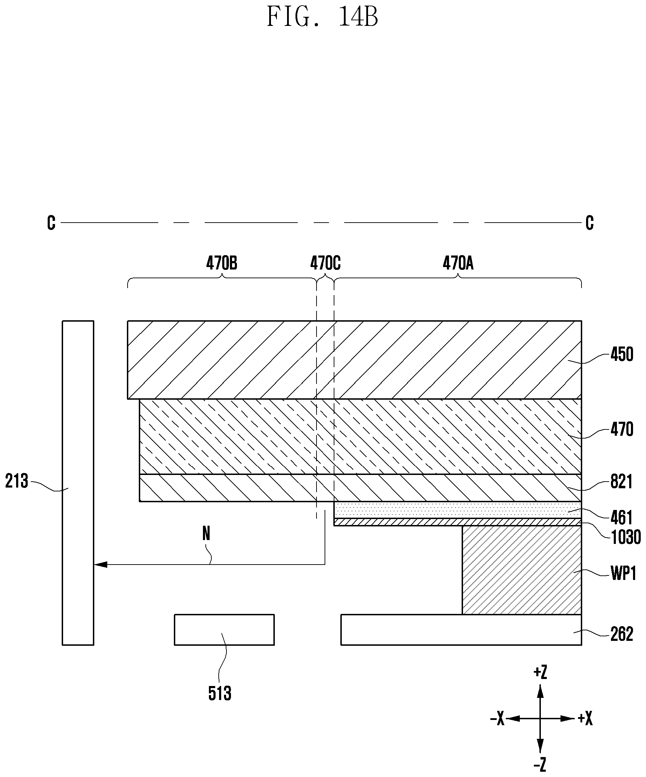

FIG. 14A is an enlarged view of S1 illustrated in FIG. 6. FIG. 14B is a cross-sectional view of an electronic device illustrated in FIG. 14A, cut along line C-C of FIG. 14A.

Hereinafter, an electronic device (e.g., electronic device 200 of FIG. 3) according to another embodiment, which is different from the electronic device as described above with reference to FIGS. 9A to 12B, will be described. In the following description, detailed description of the constituent elements which are the same as or similar to the above-described constituent elements will be omitted.

Hereinafter, for convenience in explanation, explanation will be made with a focus on the first digitizer panel 471 disposed on the first housing (e.g., first housing 210 of FIG. 3), the first reinforcing plate 461 that supports the first digitizer panel 471 on the first housing 210, and their surrounding constituent elements. A part that is described hereinafter is related to an embodiment in which a part of an edge (e.g., area corresponding to S1 of FIG. 6) of the first reinforcing plate 461 supporting the digitizer panel 470 is removed. Since a part of an edge (e.g., area corresponding to S2 of FIG. 6) of the second reinforcing plate (e.g., second reinforcing plate 462 of FIG. 7) may be removed, the contents to be described hereinafter can be applied even to the removal area (e.g., removal area 464A) of the second reinforcing plate 462 and the surrounding constituent elements in the same manner. For example, it may be understood that the first reinforcing plate 461 to be described hereinafter may be replaced by the second reinforcing plate 462. Further, the first side member 213 and the second side member 223 will be described, being unified as the side member 213.

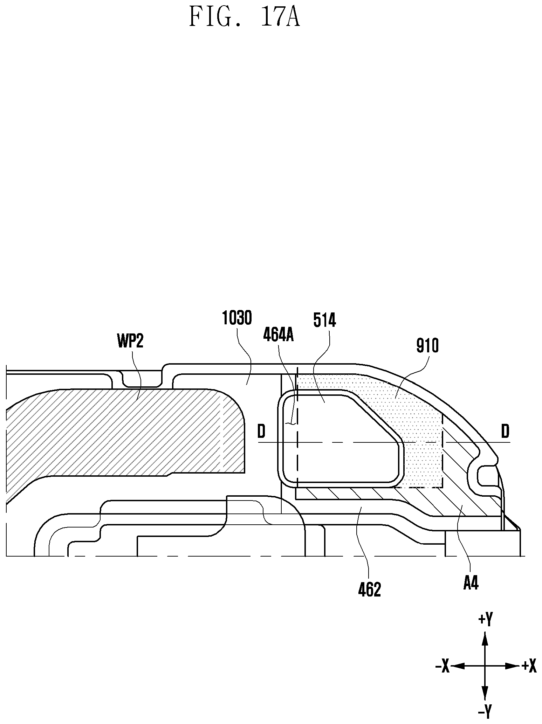

According to various embodiments, as illustrated in FIG. 14A, the third magnet 513 may be disposed in an edge area (e.g., S1 of Fig. 6) of the first housing. With reference to FIG. 17A to be described later, a fourth magnet 514 may be disposed at an edge of the second housing. The third magnet 513 and the fourth magnet 514 may be disposed at the edges of the electronic device, and may fix the folded state of the electronic device through the magnetic force. For example, with reference to FIG. 14A, the third magnet 513 may be disposed in a third removal area 463A included in the first reinforcing plate 461. Further, the fourth magnet 514 may be disposed in a fourth removal area 464A included in the second reinforcing plate 462 of FIG. 17A to be described later. When the electronic device is in a folded state, and the first reinforcing plate 461 and the second reinforcing plate 462 face each other, the folded state of the electronic device may be fixed by attraction forces of the third magnet 513 and the fourth magnet 514.

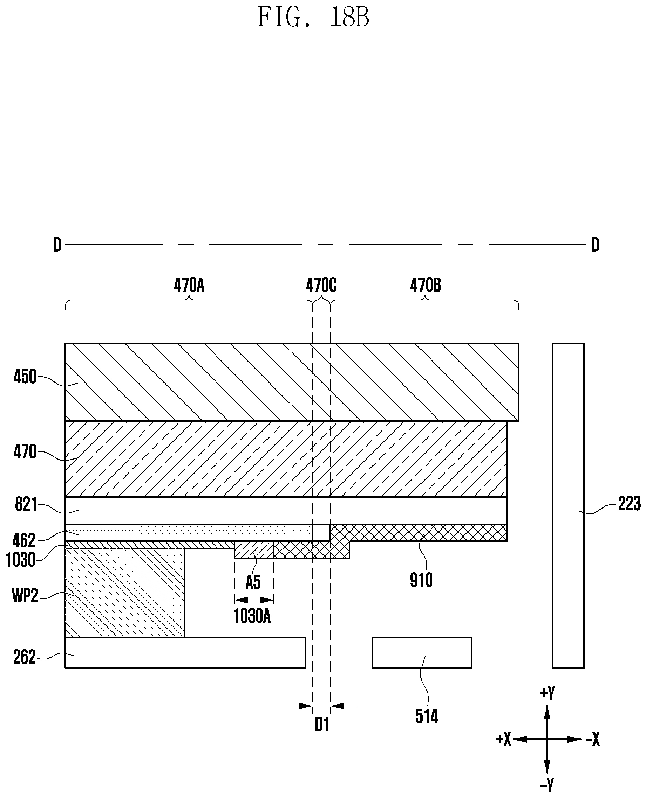

In an embodiment, on the rear surface (e.g., surface directed in -Z direction based on FIG. 14B) of the first digitizer panel 471, the shielding member 821 and the first reinforcing plate 461 may be disposed. In the following description, to help understanding of the disclosure, the first digitizer panel 471 is divided into a plurality of areas. The second digitizer panel 472 (e.g., second digitizer panel 472 of FIG. 18B) to be described later may also be applied in the same manner. Each of the areas of the first digitizer panel 471 is not an actually visually or physically divided area, and may be understood as a divided area depending on the location of the constituent element disposed to face the first digitizer panel 471 or to be adjacent to the first digitizer panel 471.

With reference to FIG. 14B, the first area 470A of the first digitizer panel 471 may be an area corresponding to a part where the first reinforcing plate 461 is disposed. The second area 470B of the first digitizer panel 471 may be an area corresponding to a part where the third magnet 513 is disposed. Further, the second area 470B of the first digitizer panel 471 may be an area that is adjacent to the side member (e.g., first side member 213) of the electronic device. The third area 470C of the first digitizer panel 471 may be between the first area 470A and the second area 470B. The third removal area 463A of the first reinforcing plate 461 as described above is an area where the first reinforcing plate 461 does not exist, and may correspond to an area including the second area 470B and the third area 470C. In an embodiment, the third removal area 463A of the first reinforcing plate 461 may be located at the edge (e.g., S1 of FIG. 6) of the electronic device 200.

As described above with reference to FIGS. 8A to 8C, if MMP included in the digitizer panel 470 (e.g., first digitizer panel 471 and the second digitizer panel 472) is saturated, an eddy current may be produced in the conductive member disposed around the digitizer panel 470. Since the eddy current is produced in the conductive member disposed around the digitizer panel 470 by the saturated MMP, it may be necessary to remove the conductive member between the magnetic component (e.g., third magnet 513 and fourth magnet 514) having the magnetic force over a predetermined level and the digitizer panel 470 including the MMP. For example, the third removal area 463A of the first reinforcing plate 461 may be an area from which one area of the first reinforcing plate 461 corresponding to the magnetic component (e.g., third magnet 513) is removed. In the same manner, the fourth removal area 464A of the second reinforcing plate 462 may be an area from which one area of the second reinforcing plate 462 corresponding to the magnetic component (e.g., fourth magnet 514) is removed. In case that the conductive member does not exist between the magnetic component and the MMP, the eddy current is not produced even if the MMP is saturated, and thus the digitizer panel 470 can operate normally.

As illustrated in FIG. 14B, the first reinforcing plate 461 that is a conductive member may be located only in a part corresponding to the first area 470A of the first digitizer panel 471, and may not be disposed in the second area 470B corresponding to the part where the third magnet 513 is disposed. The first reinforcing plate 461 that is the conductive member may be the ground of the first digitizer panel 471. Although not illustrated in the drawing, the conductive sheet (e.g., conductive sheet 880 of FIG. 8B) may be disposed on the part corresponding to the first area 470A of the first digitizer panel 471. The conductive sheet may be the ground of the first digitizer panel 471. In the second area 470B and the third area 470C that is an area between the first area 470A and the second area 470B, the first reinforcing plate 461 or the conductive sheet 880 may not be disposed. The current for the operation of the first digitizer panel 471 may be partially abandoned in the second area 470B and the third area 470C, in which the first reinforcing plate 461 or the conductive sheet 880 is not disposed, and may act as noise N on the adjacent electronic component.

The first reinforcing plate 461 may be disposed in the first area 470A, and the shielding member 821 may be disposed on the rear surface of the first digitizer panel 471. Although not illustrated in the drawing, between the first digitizer panel 471 and the first reinforcing plate 461, the conductive sheet (e.g., conductive sheet 880 of FIG. 8B) and the adhesive member for attaching the conductive sheet to the first digitizer panel 471 and the first reinforcing plate 461 may be included. Since a free space (e.g., attachment tolerance) for adjacently disposing different constituent elements to each other is required, the digitizer panel 470 may be exposed in the third area 470C.

In an embodiment, with reference to FIG. 14B, a protection layer 1030 may be disposed on the rear surface of the first reinforcing plate 461. The protection layer 1030 may block the entrance of the moisture having entered into the electronic device into the digitizer panel 470. In an embodiment, the protection layer 1030 may be located in the first area 470A of the first digitizer panel 471.

In an embodiment, the support member (e.g., support member 262 of FIG. 8B) may be disposed in the first direction (e.g., -Z direction of FIG. 14B) with respect to the first reinforcing plate 461. The support member 261 may be a mechanical part that generally supports various electronic components disposed on the first housing 210. As illustrated in FIG. 14B, the first waterproof structure WP1 may be disposed between the support member 262 and the first reinforcing plate 461. The first waterproof structure WP1 may attach the first reinforcing plate 461 to the support member 262. Further, the first waterproof structure WP1 may seal between the first reinforce plate 461 and the support member 262, and may block the entrance of external moisture or foreign substances between the first reinforcing plate 461 and the support member 262. As illustrated in FIG. 14B, the support member 262 and the shielding member 821 may be spaced apart from each other. This may be in consideration of the surface quality (e.g., flatness) of the digitizer panel 470.

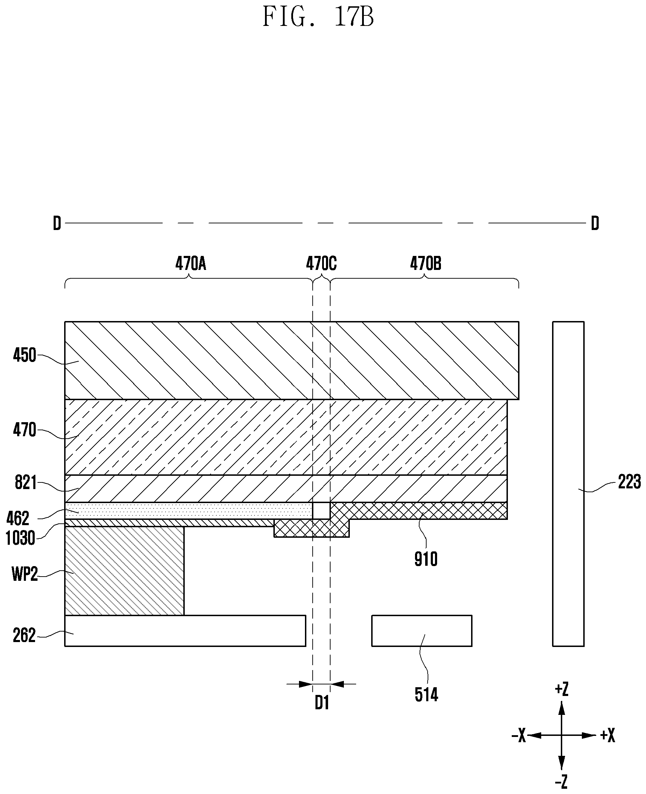

As described above with reference to FIGS. 8A to 8C, as one area of the reinforcing plate 461 and 462 is removed, current may be abandoned from the digitizer panel 470 (e.g., first digitizer panel 471 of FIG. 14B and/or second digitizer panel 472 of FIG. 17B) having one exposed area. The current N abandoned from the digitizer panel 470 may be abandoned from the area where the digitizer panel 470 is exposed (e.g., second area 470B and third area 470C of the first digitizer panel 471 of FIG. 14B) to the side member (e.g., first side member 213 and second side member 223). Due to this abandoned current N, a parasitic current is produced in the side member 213, and may exert an influence on the antenna performance of the side member 213 and 223. For example, deviation of the antenna performance may occur between the same products, and the deviation may occur in a specific frequency.

Hereinafter, various embodiments to solve the above-described problem will be described. In the following description, detailed description of the constituent elements which are the same as or similar to the above-described constituent elements will be omitted.

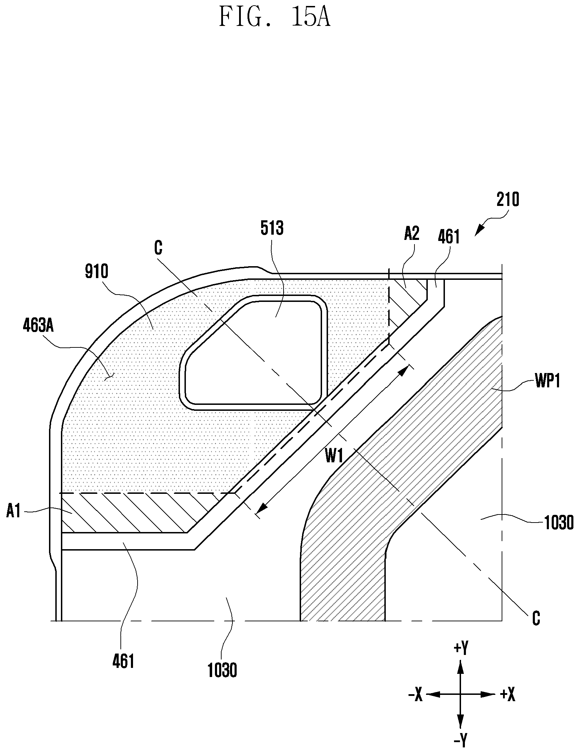

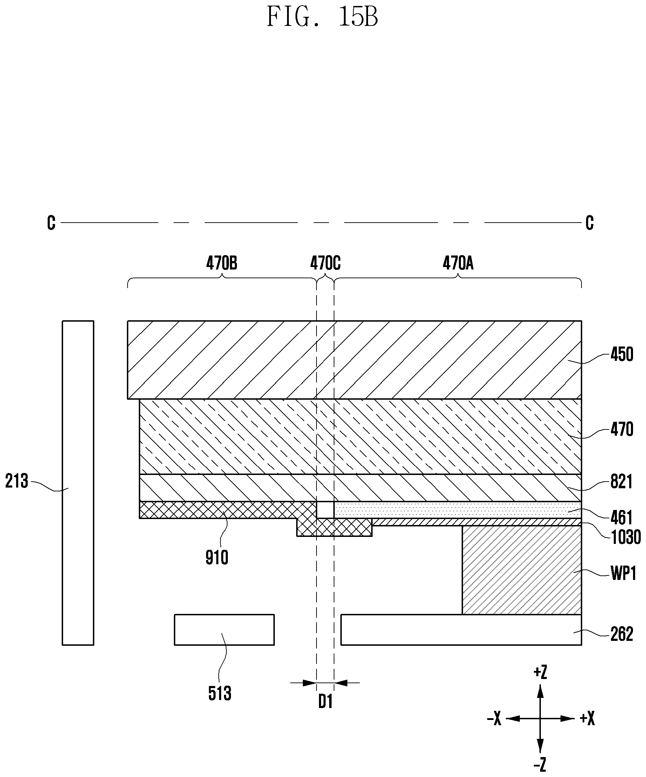

FIG. 15A is an enlarged view of S1 illustrated in FIG. 6. FIG. 15B is a cross-sectional view of an electronic device illustrated in FIG. 15A, cut along line C-C of FIG. 15A.

According to various embodiments, since the first digitizer panel 471 is exposed through the third removal area 463A of the first reinforcing plate 461, current may be abandoned from the first digitizer panel 471. As described above, the abandoned current N may exert an influence on the antenna performance of the side member 213 and 223, and may act as noise on the surrounding electronic components.

According to various embodiments, as illustrated in FIGS. 15A and 15B, the electronic device may include a middle member 910. The middle member 910 may be formed of a conductive material. The middle member 910 may be located to correspond to the second area 470A and the third area 470C of the first digitizer panel 471, and may be electrically connected to the first reinforcing plate 461 disposed in the first area 470A of the first digitizer panel 471. In an embodiment, with reference to FIG. 15B, at least a part of the middle member 910 may extend to the first area 470A of the first digitizer panel 471. For example, the middle member 910 may extend from the second area 470B to a part of the first area 470A, and may be disposed on the rear surface (surface directed in -Z direction based on FIG. 15B) of the first reinforcing plate located in the first area 470A. Since the second area 470B and the third area 470C are hidden by the middle member 910, the problem in that the current by the operation of the digitizer panel 470 is abandoned in the second area 470B and the third area 470C of the first digitizer panel 471 can be solved. The current abandoned in the second area 470B and the third area 470C may flow to the middle member 910 that is electrically connected to the first reinforcing plate 461 that functions as the ground (or that is connected to the ground). Due to this, the current abandonment problem can be reduced.

In an embodiment, the middle member 910 may be integrally formed with the first reinforcing plate 461. The middle member 910 may be formed of a flexible material that can be transformed. The middle member 910 may extend from the first reinforcing plate 461, and a partial section thereof may be bent. Accordingly, the middle member 910 disposed in the second area 470B and the third area 470C may be located farther from the first digitizer panel 471 than the first reinforcing plate 461 disposed in the first area 470A. The middle member 910 may be formed to extend so that the middle member 910 can be disposed on the rear surface (e.g., surface directed in -Z direction based on FIG. 15B) of the shielding member 821 disposed in the second area 470B. Since the middle member 910 that is integrally formed with the first reinforcing plate 461 is located in the second area 470B and the third area 470C of the first digitizer panel 471, the current abandoned in the second area 470B and the third area 470C may be blocked by the middle member 910. Accordingly, since the second area 470B and the third area 470C are hidden by the middle member 910, the problem in that the current by the operation of the digitizer panel 470 is abandoned in the second area 470B and the third area 470C of the first digitizer panel 471 can be solved.

With reference to FIG. 15A, the middle member 910 may be attached to the rear surface of the first reinforcing plate 461, and may hide the second area 470B and the third area 470C of the first digitizer panel 471. For example, as illustrated in FIG. 15A, the middle member 910 may secure areas A1 and A2 that can be attached to the first reinforcing plate 461, and may be fixed to the first reinforcing plate 461. In an embodiment, the middle member 910 may extend from the second area 470B to the first area 470A of the first digitizer panel 471, and may be attached to the first reinforcing plate 461. However, as illustrated in FIG. 15B, since the protection layer 1030 is disposed on the rear surface of the first reinforcing plate 461, the areas where the middle member 910 is attached to the first reinforcing plate 461 may be limited.

Further, in case that the middle member 910 is laminated on the protection layer 1030, the surface quality of the digitizer panel 470 may deteriorate or the thickness of the electronic device may be increased in Z-axis direction, resulting in that sealing through the waterproof structures WP1 and WP2 may not be smoothly performed. Hereinafter, schemes for being able to secure the area where the middle member 910 is attached to the first reinforcing plate 461 without being laminated on the protection layer 1030 will be described in detail.

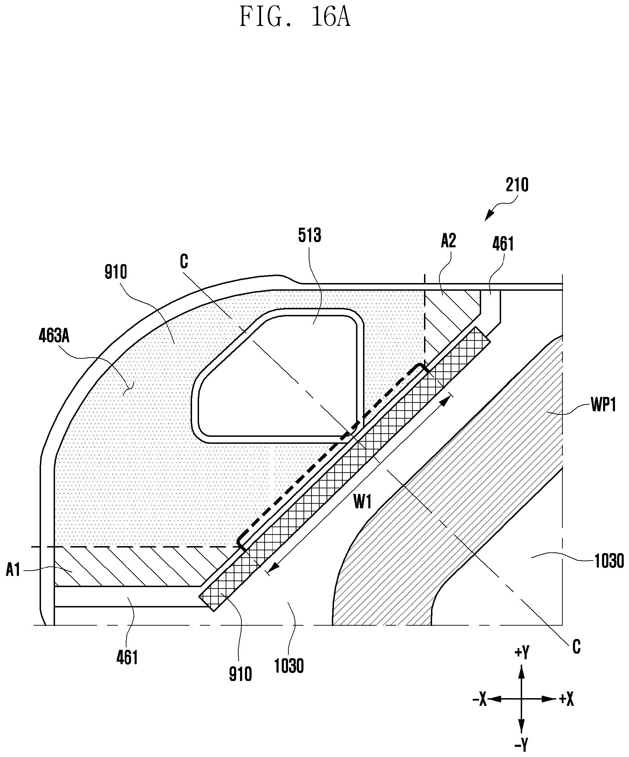

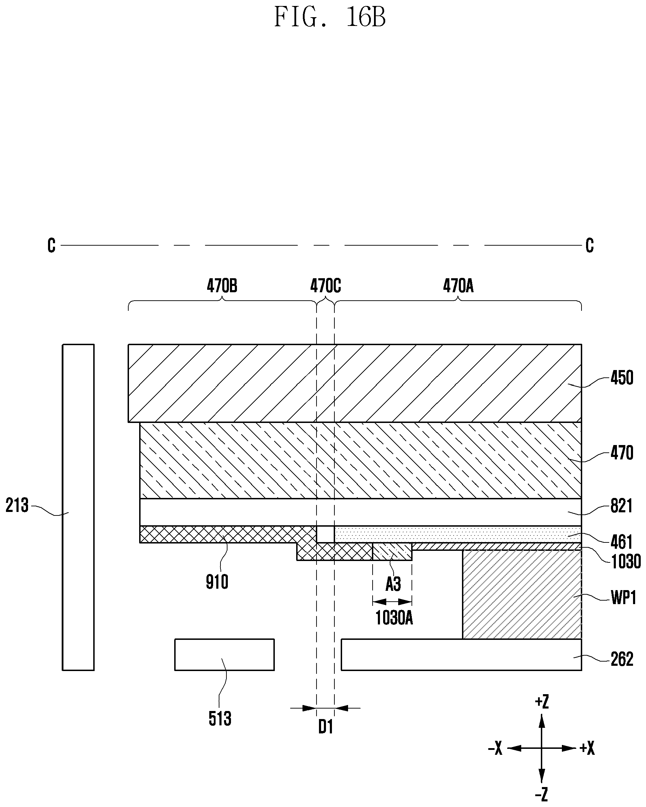

FIG. 16A is an enlarged view of S1 illustrated in FIG. 6. FIG. 16B is a cross-sectional view of an electronic device illustrated in FIG. 16A, cut along line C-C of FIG. 16A.

According to various embodiments, as illustrated in FIGS. 16A and 16B, at least a part of the protection layer 1030 disposed on the rear surface (e.g., surface directed in -Z direction based on FIG. 16B) of the first reinforcing plate 461 may be removed in the first area 470A of the first digitizer panel 471. The middle member 910 may extend from the second area 470B of the first digitizer panel 471 to the removal area 1030A of the protection layer 1030 located in the first area 470. Accordingly, the middle member 910 may secure an additional area A3 that can be attached to the protection layer 1030. Accordingly, the fixing force of the middle member 910 against the first reinforcing plate 461 can be improved.

In an embodiment, the middle member 910 and the protection layer 1030 may be disposed to come in close contact with each other on the first reinforcing plate 461. Further, when viewed from the front surface of the electronic device, the middle member 910 may not overlap the protection layer 1030.

According to various embodiments disclosed in this document, the middle member 910 may be fixed to the first reinforcing plate 461 through securing of the area (e.g., A3 of FIG. 16B) that can be attached to the first reinforcing plate 461, and may hide the second area 470B and the third area 470C of the first digitizer panel 471. Further, since the middle member 910 and the protection layer 1030 are disposed not to overlap each other in X-axis direction, the surface quality of the digitizer panel 470 can be prevented from deteriorating, and sealing through the waterproof structures WP1 and WP2 can be performed.

FIG. 17A is an enlarged view of S2 illustrated in FIG. 6. FIG. 17B is a cross-sectional view of an electronic device illustrated in FIG. 17A, cut along line D-D of FIG. 17A.

The contents to be described hereinafter are related to the removal area (e.g., fourth removal area 464A) of the second reinforcing plate 462 and the surrounding constituent elements. The contents may be substantially the same as the contents related to the removal area (e.g., third removal area 463A) of the first reinforcing plate 461 and the surrounding constituent elements as described above with reference to FIGS. 14A to 16B. Hereinafter, description of the contents similar to the contents as described above with reference to FIGS. 14A to 16B will be omitted.

With reference to FIG. 17B, the first area 470A of the second digitizer panel 472 may be an area corresponding to a part where the second reinforcing plate 462 is disposed. The second area 470B of the second digitizer panel 472 may be an area corresponding to an area where the fourth magnet 514 is disposed. Further, the second area 470B of the second digitizer panel 472 may be an area adjacent to the side member (e.g., second side member 223) of the electronic device. The third area 470C of the second digitizer panel 472 may be between the first area 470A and the second area 470B. The fourth removal area 464A of the second reinforcing plate 462 as described above may be an area where the second reinforcing plate 462 does not exist, and may correspond to an area including the second area 470B and the third area 470C. In an embodiment, the fourth removal area 464A of the second reinforcing plate 462 may be located at a corner (e.g., S2 of FIG. 6) of the electronic device 200.

According to various embodiments, since the second digitizer panel 472 is exposed through the fourth removal area 464A of the second reinforcing plate 462, current may be abandoned from an area (e.g., second area 470B and third area 470C of the second digitizer panel 472) where the second digitizer panel 472 is exposed. As described above, the abandoned current N may exert an influence on the antenna performance of the side member 213 and 223, and may act as noise on the surrounding electronic components.

According to various embodiments, as illustrated in FIGS. 17A and 17B, the electronic device may include a middle member 910. The middle member 910 may be formed of a conductive material. The middle member 910 may be located to correspond to the second area 470A and the third area 470C of the second digitizer panel 472, and may be electrically connected to the second reinforcing plate 462 disposed in the first area 470A of the second digitizer panel 472. In an embodiment, with reference to FIG. 17B, at least a part of the middle member 910 may extend to the first area 470A of the second digitizer panel 472. For example, the middle member 910 may extend from the second area 470B to a part of the first area 470A, and may be disposed on the rear surface (surface directed in -Z direction based on FIG. 15B) of the second reinforcing plate 462 located in the first area 470A. Since the second area 470B and the third area 470C are hidden by the middle member 910, the problem in that the current by the operation of the digitizer panel 470 is abandoned in the second area 470B and the third area 470C of the second digitizer panel 472 can be solved. The current abandoned in the second area 470B and the third area 470C may flow to the middle member 910 that is electrically connected to the second reinforcing plate 462 that functions as the ground (or that is connected to the ground). Due to this, the current abandonment problem can be reduced.

With reference to FIG. 17A, the middle member 910 may be attached to the rear surface of the second reinforcing plate 462, and may hide the second area 470B and the third area 470C of the second digitizer panel 472. For example, as illustrated in FIG. 17A, the middle member 910 may be fixed to the second reinforcing plate 462 through securing of the area (A4) that can be attached to the second reinforcing plate 462.

In an embodiment, the middle member 910 may extend from the second area 470B to the first area 470A of the second digitizer panel 472, and may be attached to the second reinforcing plate 462. However, as illustrated in FIG. 17B, since the protection layer 1030 is disposed on the rear surface (e.g., surface directed in -Z direction based on FIG. 17B) of the second reinforcing plate 462, the areas where the middle member 910 is attached to the second reinforcing plate 462 may be limited. Further, in case that the middle member 910 is laminated on the protection layer 1030, the surface quality of the digitizer panel 470 may deteriorate or the thickness of the electronic device may be increased in Z-axis direction, resulting in that sealing through the waterproof structures WP1 and WP2 may not be smoothly performed. Hereinafter, schemes for being able to secure the area where the middle member 910 is attached to the second reinforcing plate 462 without being laminated on the protection layer 1030 will be described in detail.

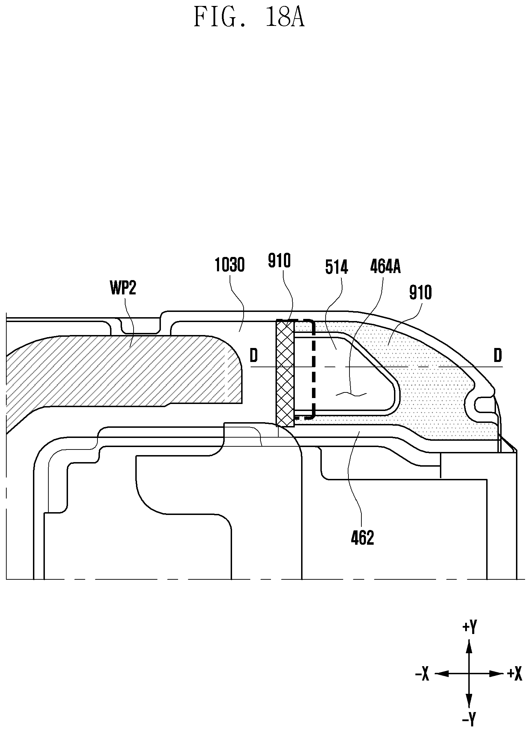

FIG. 18A is an enlarged view of S2 illustrated in FIG. 6. FIG. 18B is a cross-sectional view of an electronic device illustrated in FIG. 18A, cut along line D-D of FIG. 18A.

According to various embodiments, as illustrated in FIGS. 18A and 18B, at least a part of the protection layer 1030 disposed on the rear surface (e.g., surface directed in -Z direction based on FIG. 18B) of the second reinforcing plate 462 may be removed in the first area 470A of the second digitizer panel 472. The middle member 910 may extend from the second area 470B of the second digitizer panel 472 to the removal area 1030A of the protection layer 1030 located in the first area 470. Accordingly, the middle member 910 may secure an additional area A5 that can be attached to the protection layer 1030. Accordingly, the fixing force of the middle member 910 against the second reinforcing plate 462 can be improved.

In an embodiment, the middle member 910 and the protection layer 1030 may be disposed to come in close contact with each other on the second reinforcing plate 462. Further, when viewed from the front surface of the electronic device, the middle member 910 may not overlap the protection layer 1030.

According to various embodiments disclosed in this document, the middle member 910 may be fixed to the second reinforcing plate 462 through securing of the area (e.g., A5 of FIG. 18B) that can be attached to the second reinforcing plate 462, and may hide the second area 470B and the third area 470C of the first digitizer panel 471. Further, since the middle member 910 and the protection layer 1030 are disposed not to overlap each other in Z-axis direction, the surface quality of the digitizer panel 470 can be prevented from deteriorating, and sealing through the waterproof structures WP1 and WP2 can be performed.

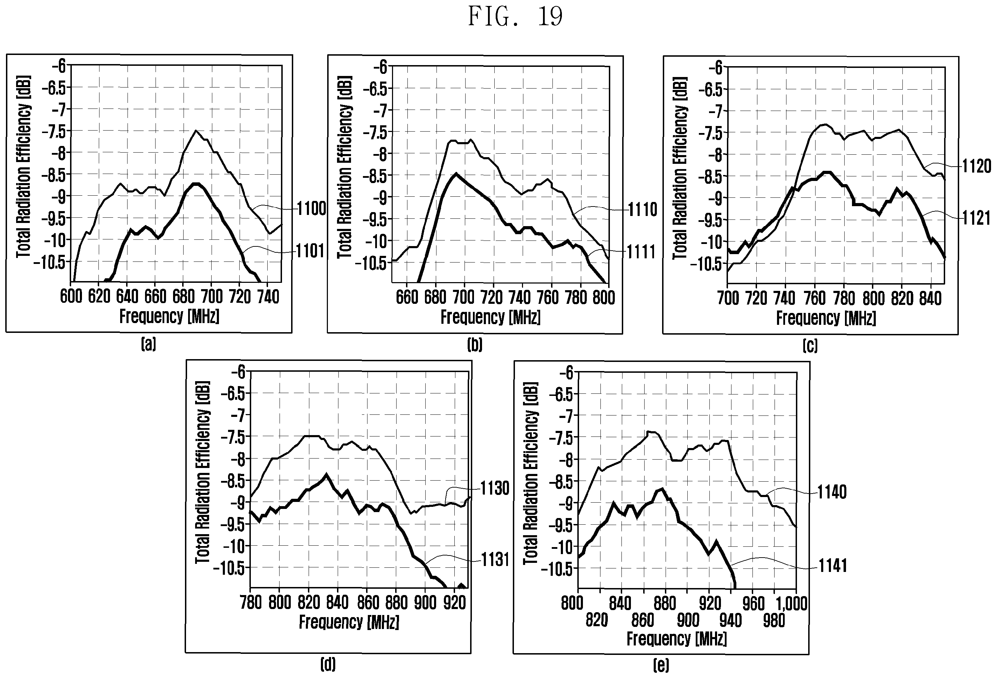

FIG. 19 is a diagram capable of identifying an antenna radiation deviation of an electronic device illustrated in FIGS. 14A to 18B.

An antenna included in the electronic device (e.g., electronic device 200 of FIG. 1A) may transmit or receive various frequency band signals. In FIG. 19, (a) to (e) are graphs identifying a difference in antenna radiation performance in different frequency bands.

According to various embodiments, the graphs 1101, 1111, 1121, 1131, and 1141 illustrated in (a) to (e) of FIG. 19 represent the result of experimenting antenna radiation deviation in different frequencies in an electronic device including a structure in which the third area 470C of the digitizer panel 470 (e.g., first digitizer panel 471 and/or second digitizer panel 472) is in an exposed state (hereinafter, called "first embodiment"). The graphs 1100, 1110, 1120, 1130, and 1140 illustrated in (a) to (e) of FIG. 19 represent the result of experimenting antenna radiation deviation in different frequencies in an electronic device including a structure in which the third area 470C of the digitizer panel 470 is in a shielded state by the middle member 910 (hereinafter, called "second embodiment"). As described above through the drawings, the second embodiment may be understood as an electronic device having a structure in which the third area 470C of the digitizer panel 470 is hidden by the middle member 910.

In comparison of the graphs illustrated in FIG. 19 with each other, it can be identified that the antenna radiation deviation according to the frequency in the second embodiment is better than that in the first embodiment. As described above, by shielding the third area 470C of the digitizer panel 470 with the middle member 910, the antenna radiation deviation according to the frequency can be reduced, thereby improving the radiation performance

As described above, in FIGS. 9A to 12B and 14A to 18B, although the part (e.g., second area 470B and/or third area 470C) where the "digitizer panel 470" is exposed has been described, the structure as described above with reference to FIGS. 9A to 12B and 14A to 18B may be applied even to the display module 230 that does not include the digitizer panel 470 in the same manner.

For example, by covering the part where the substrate (e.g., substrate (e.g., substrate 4322 of FIG. 4) of the display panel (e.g., display panel 430 of FIG. 4) included in the display module 230 with the middle member 910, the phenomenon in which the current abandoned in the part where the substrate is exposed exerts an influence on the side member 213 and 223 that functions as an antenna can be prevented.

Accordingly, a part described above as a digitizer panel may be understood to be replaced by a "display substrate".

An electronic device (e.g., electronic device 200 of FIG. 1A) according to various embodiments disclosed in this document may include: a housing including a first housing (e.g., first housing 210 of FIG. 1A) and a second housing (e.g., second housing 220 of FIG. 1A) rotatably connected to the first housing; a side member (e.g., side member 213 and 223 of FIG. 1A) constituting a side exterior of the electronic device and formed of a conductive material; a digitizer panel (e.g., digitizer panel 470 of FIG. 9B) including a first area (e.g., first area 470A of FIG. 9B), a second area (e.g., second area 470B of FIG. 9B) adjacent to the side member, and a third area (e.g., third area 470C of FIG. 9B) between the first area and the second area, and disposed on the first housing and the second housing; a reinforcing plate (e.g., reinforcing plate 461 of FIG. 9B) located to correspond to the first area of the digitizer panel, configured to support the digitizer panel, and formed of a conductive material; a magnet member (e.g., magnet member 511 of FIG. 9B) disposed at a location corresponding to the second area of the digitizer panel; and a middle member (e.g., middle member 910 of FIG. 9B) located to correspond to the second area and the third area of the digitizer panel, formed of a conductive material, and electrically connected to the reinforcing plate.

Further, the electronic device may further include a shielding member (e.g., shielding member 821 of FIG. 9B) including a magnetic shielding material, and disposed between the second area of the digitizer panel and the magnet member.

Further, at least a part of the shielding member may be disposed to come in close contact with the second area of the digitizer panel.

Further, the electronic device may further include: a support member (e.g., support member 262 of FIG. 9B) disposed in a first direction (e.g., -Z direction based on FIG. 9B) with respect to the reinforcing plate; and a waterproof member (e.g., first waterproof structure WP1 of FIG. 6, second waterproof structure WP2, or waterproof member 481 of FIG. 9B) disposed between the support member and the reinforcing plate, and configured to attach the reinforcing plate to the support member and to seal between the support member and the reinforcing plate.

Further, the middle member may be disposed to be spaced apart from the support member.

Further, the electronic device may further include a conductive sheet (e.g., conductive sheet 880 of FIG. 9B) disposed between the digitizer panel and the reinforcing plate at a location corresponding to the first area of the digitizer panel.

Further, the middle member may be integrally formed with the reinforcing plate.

Further, the middle member may be formed to start from the reinforcing plate corresponding to the first area of the digitizer panel, to be bent at a partial section of the middle member, and to extend up to a location corresponding to the second area of the digitizer panel.

Further, the middle member (e.g., middle member 910 of FIG. 10B) may be formed separately from the reinforcing plate, and may be electrically connected to the reinforcing plate by a conductive connection member (e.g., conductive connection member 920 of FIG. 10B) disposed between the middle member and the reinforcing plate.

Further, the electronic device may include: a first shielding member (e.g., first shielding member 8211 of FIG. 11B) including a magnetic shielding material, disposed between the second area of the digitizer panel and the magnet member, and coming in close contact with the second area of the digitizer panel; and a second shielding member (e.g., second shielding member 8212 of FIG. 11B) disposed at a location corresponding to the second area of the digitizer panel, and disposed to be spaced apart from the first shielding member, wherein the middle member may be disposed between the first shielding member and the second shielding member, and is electrically connected to the reinforcing plate.

Further, the digitizer panel may further include a fourth area (e.g., fourth area 470D of FIG. 12B) configured to be more adjacent to the side member than the second area, and to overlap a side housing (e.g., side housing 801 of FIG. 12A) at least partly disposed on a border of a front surface of the electronic device when viewed from the front surface of the electronic device, and the middle member may have one end electrically connected to the reinforcing plate, and is formed to extend up to the fourth area of the digitizer panel.

An electronic device (e.g., electronic device 200 of FIG. 1A) according to various embodiments disclosed in this document may include: a housing including a first housing (e.g., first housing 210 of FIG. 1A) and a second housing (e.g., second housing 220 of FIG. 1A) rotatably connected to the first housing; a side member (e.g., side member 213 and 223 of FIG. 1A) constituting a side exterior of the electronic device and formed of a conductive material; a digitizer panel (e.g., digitizer panel 470 of FIG. 16B) including a first area (e.g., first area 470A of FIG. 16B), a second area (e.g., second area 470B of FIG. 16B) adjacent to the side member, and a third area (e.g., third area 470C of FIG. 16B) between the first area and the second area, and disposed on the first housing and the second housing; a reinforcing plate (e.g., first reinforcing plate 461 of FIG. 16B and/or second reinforcing plate 462 of FIG. 16B) located to correspond to the first area of the digitizer panel, configured to support the digitizer panel, and formed of a conductive material; a magnet member (e.g., third magnet 513 of FIG. 16A) disposed at a location corresponding to the second area of the digitizer panel; a middle member (e.g., middle member 910 of FIG. 16B) located to correspond to the second area and the third area of the digitizer panel, having at least a part disposed to extend to the first area of the digitizer panel, formed of a conductive material, and electrically connected to the reinforcing plate; and a protection layer (e.g., protection layer 1030 of FIG. 16B) located in the first area of the digitizer panel, and located on a rear surface of the reinforcing plate.

Further, the electronic device may further include a shielding member (e.g., shielding member 821 of FIG. 16B) including a magnetic shielding material, and disposed on a rear surface of the digitizer panel.

Further, at least a part of the middle member may be disposed to come in close contact with the protection layer on a rear surface of the reinforcing plate.

Further, the middle member may be disposed not to overlap the protection layer when viewed from a front surface of the electronic device (e.g., -Z direction based on FIG. 16B).

Further, the magnet member may be located at a corner (e.g., S1 and S2 of FIG. 6) of the electronic device.

Further, the protection layer may include a removal area (e.g., removal area 1030A of FIG. 16B) removed at least partly on the first area of the digitizer panel, and the middle member may be configured to extend from the second area of the digitizer panel to the removal area located in the first area.

Further, the electronic device may further include: a support member (e.g., support member 262 of FIG. 16B) disposed in a first direction (e.g., -Z direction based on FIG. 16B) with respect to the reinforcing plate; and a waterproof member (e.g., first waterproof structure WP1 of FIG. 16B and second waterproof structure WP2 of FIG. 18B) disposed between the support member and the reinforcing plate, and configured to attach the reinforcing plate to the support member and to seal between the support member and the reinforcing plate.

Further, the middle member may be disposed to be spaced apart from the support member.

Further, the middle member may be formed to start from the reinforcing plate corresponding to the first area of the digitizer panel, to be bent at a partial section of the middle member, and to extend up to a location corresponding to the second area of the digitizer panel.

On the other hand, the embodiments of the disclosure disclosed in the specification and drawings as described above are merely to present specific examples in order to facilitate the technical contents according to the embodiments disclosed in this document and to help understanding of the embodiments disclosed in this document, but are not intended to limit the scope of the embodiments disclosed in this document.

## Claims

1. An electronic device (100, 200) comprising:
a housing including a first housing (210) and a second housing (220) rotatably connected to the first housing with reference to a folding axis;
a side member (213, 223) constituting a side exterior of the electronic device and formed of a conductive material;
a digitizer panel (470) including a first area (470A), a second area (470B) adjacent to the side member (213, 223), and a third area (470 C) between the first area and the second area, and disposed on the first housing (210) and the second housing (220);
a reinforcing plate (461) located to correspond to the first area (470A)of the digitizer panel (470), configured to support the digitizer panel (470), and formed of a conductive material;
a magnet member (511) disposed at a location corresponding to the second area (470 B) of the digitizer panel;
a middle member (910) located to correspond to the second area and the third area (470C) of the digitizer panel, formed of a conductive material, and connected to the reinforcing plate; and
a shielding member (821) including a magnetic shielding material, and disposed between the second area of the digitizer panel (470) and the magnet member (511),
wherein the middle member is disposed between the shielding member and the magnet member

2. The electronic device (100, 200) of claim 1, further comprising:
a support member (262) disposed in a first direction with respect to the reinforcing plate (461); and
a waterproof member (481) disposed between the support member (262) and the reinforcing plate (461), and configured to attach the reinforcing plate (461) to the support member (262)and to seal between the support member (262) and the reinforcing plate (461).

3. The electronic device (100, 200) of claim 1, further comprising a conductive sheet (880) disposed between the digitizer panel (470) and the reinforcing plate (461) at a location corresponding to the first area (470A) of the digitizer panel (470).

4. The electronic device (100, 200) of claim 1, wherein the middle member (910) is integrally formed with the reinforcing plate,(461) .

5. The electronic device (100, 200) of claim 4, wherein the middle member (910) is formed to start from the reinforcing plate (461) corresponding to the first area (470A) of the digitizer panel (470), to be bent at a partial section of the middle member (910), and to extend up to a location corresponding to the second area (470B)of the digitizer panel (470).

6. The electronic device (100, 200) of claim 1, wherein the middle member (910)is formed separately from the reinforcing plate (461) , and is electrically connected to the reinforcing plate (461) by a conductive connection member (920) disposed between the middle member (910) and the reinforcing plate (461).

7. The electronic device (100, 200) of claim 1, wherein the shielding member comprises:
a first shielding member (810) including a magnetic shielding material, disposed between the second area (470B) of the digitizer panel (470) and the middle member (910), and coming in close contact with the second area (470B) of the digitizer panel (470); and
a second shielding member (820) disposed at a location corresponding to the second area (470B)of the digitizer panel, and positioned between the magnet member and the middle member.

8. The electronic device of claim 1, wherein the digitizer panel (470) further comprises a fourth area (470D) configured to be more adjacent to the side member (213, 223) than the second area (470B), and to overlap a side housing at least partly disposed on a border of a front surface of the electronic device when viewed from the front surface of the electronic device, and
wherein the middle member (910) has one end electrically connected to the reinforcing plate (461), and is configured to extend up to the fourth area (470D) of the digitizer panel (470).

9. The electronic device according to claim 1, wherein the middle member extends at least partially into the first area of the digitizer panel, and is in contact with a rear surface of the reinforcing plate,
wherein the electronic device further comprises a protection layer (1030) positioned in the first area (470A) of the digitizer panel (470) and located on the rear surface of the reinforcing plate (461) without overlapping with the middle member when viewed from a front surface of the electronic device .

10. The electronic device (100, 200) of claim 9, further comprising a shielding member (821) including a magnetic shielding material, and disposed on a rear surface of the digitizer panel (470).

11. The electronic device (100, 200) of claim 9, wherein at least a part of the middle member (910) is disposed to come in close contact with the protection layer (1030) on a rear surface of the reinforcing plate (461).

12. The electronic device (100, 200) of claim 9, wherein the magnet member (511) is located at a corner of the electronic device(100, 200).

13. The electronic device (100, 200) of claim 9, wherein the protection layer (1030) comprises a removal area (1030A) removed at least partly on the first area (470A) of the digitizer panel, and wherein the middle member (910) is configured to extend from the second area (470B) of the digitizer panel (470) to the removal area (1030A) located in the first area (470A).

14. The electronic device (100, 200) of claim 1,
wherein a distance(L2) between the digitizer panel and the middle member is greater than a distance(L1) between the digitizer panel and the reinforcing plate.

## Patentansprüche

1. Elektronische Vorrichtung (100, 200), die Folgendes umfasst:
ein Gehäuse, das ein erstes Gehäuse (210) und ein zweites Gehäuse (220) enthält, das mit dem ersten Gehäuse in Bezug auf eine Faltachse drehbar verbunden ist;
ein Seitenelement (213, 223), das eine seitliche Außenseite der elektronischen Vorrichtung bildet und aus einem leitfähigen Material besteht;
eine Digitalisierplatte (470), die einen ersten Bereich (470A), einen zweiten Bereich (470B) neben dem Seitenelement (213, 223) und einen dritten Bereich (470 C) zwischen dem ersten Bereich und dem zweiten Bereich enthält und auf dem ersten Gehäuse (210) und dem zweiten Gehäuse (220) angeordnet ist;
eine Verstärkungsplatte (461), die so angeordnet ist, dass sie dem ersten Bereich (470A) der Digitalisierplatte (470) entspricht, und so konfiguriert ist, dass sie die Digitalisierplatte (470) stützt und aus einem leitfähigen Material besteht;
ein Magnetelement (511), das an einer Stelle angeordnet ist, die dem zweiten Bereich (470 B) der Digitalisierplatte entspricht;
ein mittleres Element (910), das so angeordnet ist, dass es dem zweiten Bereich und dem dritten Bereich (470C) der Digitalisierplatte entspricht, das aus einem leitfähigen Material besteht und mit der Verstärkungsplatte verbunden ist; und
ein Abschirmelement (821), das ein magnetisches Abschirmmaterial enthält und zwischen dem zweiten Bereich der Digitalisierplatte (470) und dem Magnetelement (511) angeordnet ist,
wobei das mittlere Element zwischen dem Abschirmelement und dem Magnetelement angeordnet ist.

2. Elektronische Vorrichtung (100, 200) nach Anspruch 1, die ferner Folgendes umfasst:
ein Stützelement (262), das in einer ersten Richtung in Bezug auf die Verstärkungsplatte (461) angeordnet ist; und
ein wasserdichtes Element (481), das zwischen dem Stützelement (262) und der Verstärkungsplatte (461) angeordnet ist und so konfiguriert ist, dass es die Verstärkungsplatte (461) an dem Stützelement (262) befestigt und zwischen dem Stützelement (262) und der Verstärkungsplatte (461) abdichtet.

3. Elektronische Vorrichtung (100, 200) nach Anspruch 1, die ferner eine leitfähige Folie (880) umfasst, die zwischen der Digitalisierplatte (470) und der Verstärkungsplatte (461) an einer Stelle angeordnet ist, die dem ersten Bereich (470A) der Digitalisierplatte (470) entspricht.

4. Elektronische Vorrichtung (100, 20) nach Anspruch 1, wobei das mittlere Element (910) einstückig mit der Verstärkungsplatte (461) ausgebildet ist.

5. Elektronische Vorrichtung (100, 200) nach Anspruch 4, wobei das mittlere Element (910) so ausgebildet ist, dass es von der Verstärkungsplatte (461) ausgeht, die dem ersten Bereich (470A) der Digitalisierplatte (470) entspricht, an einem Teilabschnitt des mittleren Elements (910) gebogen ist und sich bis zu einer Stelle erstreckt, die dem zweiten Bereich (470B) der Digitalisierplatte (470) entspricht.

6. Elektronische Vorrichtung (100, 200) nach Anspruch 1, wobei das mittlere Element (910) separat von der Verstärkungsplatte (461) ausgebildet ist und über ein zwischen dem mittleren Element (910) und der Verstärkungsplatte (461) angeordnetes leitfähiges Verbindungselement (920) mit der Verstärkungsplatte (461) elektrisch verbunden ist.

7. Elektronische Vorrichtung (100, 200) nach Anspruch 1, wobei das Abschirmelement Folgendes umfasst:
ein erstes Abschirmelement (810), das ein magnetisches Abschirmmaterial enthält, das zwischen dem zweiten Bereich (470B) der Digitalisierplatte (470) und dem mittleren Element (910) angeordnet ist und in engen Kontakt mit dem zweiten Bereich (470B) der Digitalisierplatte (470) kommt; und
ein zweites Abschirmelement (820), das an einer Stelle angeordnet ist, die dem zweiten Bereich (470B) der Digitalisierplatte entspricht, und zwischen dem Magnetelement und dem mittleren Element angeordnet ist.

8. Elektronische Vorrichtung nach Anspruch 1, wobei die Digitalisierplatte (470) ferner einen vierten Bereich (470D) umfasst, der so konfiguriert ist, dass er näher an dem Seitenelement (213, 223) als der zweite Bereich (470B) liegt und ein Seitengehäuse überlappt, das zumindest teilweise an einer Grenze einer Vorderseite der elektronischen Vorrichtung angeordnet ist, wenn von der Vorderseite der elektronischen Vorrichtung aus betrachtet, und
wobei das mittlere Element (910) ein Ende aufweist, das mit der Verstärkungsplatte (461) elektrisch verbunden ist, und so konfiguriert ist, dass es sich bis zu dem vierten Bereich (470D) der Digitalisierplatte (470) erstreckt.

9. Elektronische Vorrichtung nach Anspruch 1, wobei sich das mittlere Element zumindest teilweise in den ersten Bereich der Digitalisierplatte erstreckt und mit einer Rückseite der Verstärkungsplatte in Kontakt steht,
wobei die elektronische Vorrichtung ferner eine Schutzschicht (1030) umfasst, die in dem ersten Bereich (470A) der Digitalisierplatte (470) angeordnet ist und sich auf der Rückseite der Verstärkungsplatte (461) befindet, ohne sich mit dem mittleren Element zu überlappen, wenn von einer Vorderseite der elektronischen Vorrichtung aus betrachtet.

10. Elektronische Vorrichtung (100, 200) nach Anspruch 9, die ferner ein Abschirmelement (821) umfasst, das ein magnetisches Abschirmmaterial enthält und auf einer Rückseite der Digitalisierplatte (470) angeordnet ist.

11. Elektronische Vorrichtung (100, 200) nach Anspruch 9, wobei zumindest ein Teil des mittleren Elements (910) so angeordnet ist, dass er in engen Kontakt mit der Schutzschicht (1030) auf einer Rückseite der Verstärkungsplatte (461) kommt.

12. Elektronische Vorrichtung (100, 200) nach Anspruch 9, wobei sich das Magnetelement (511) an einer Ecke der elektronischen Vorrichtung (100, 200) befindet.

13. Elektronische Vorrichtung (100, 200) nach Anspruch 9, wobei die Schutzschicht (1030) einen Entfernungsbereich (1030A) umfasst, der zumindest teilweise auf dem ersten Bereich (470A) der Digitalisierplatte entfernt wurde, und wobei das mittlere Element (910) so konfiguriert ist, dass es sich von dem zweiten Bereich (470B) der Digitalisierplatte (470) bis zu dem Entfernungsbereich (1030A) erstreckt, der sich in dem ersten Bereich (470A) befindet.

14. Elektronische Vorrichtung (100, 20) nach Anspruch 1,
wobei eine Distanz (L2) zwischen der Digitalisierplatte und dem mittleren Element größer als eine Distanz (L1) zwischen der Digitalisierplatte und der Verstärkungsplatte ist.

## Revendications

1. Dispositif électronique (100, 200) comprenant :
un boîtier incluant un premier boîtier (210) et un deuxième boîtier (220) relié de manière rotative au premier boîtier par rapport à un axe de pliage ;
un élément latéral (213, 223) constituant un extérieur latéral du dispositif électronique et formé d'un matériau conducteur ;
un panneau de numérisation (470) incluant une première zone (470A), une deuxième zone (470B) adjacente à l'élément latéral (213, 223) et une troisième zone (470C) entre la première zone et la deuxième zone, et disposé sur le premier boîtier (210) et le deuxième boîtier (220) ;
une plaque de renfort (461) située de manière à correspondre à la première zone (470A) du panneau de numérisation (470), configurée pour supporter le panneau de numérisation (470) et formée d'un matériau conducteur ;
un élément d'aimant (511) disposé à un emplacement correspondant à la deuxième zone (470B) du panneau de numérisation ;
un élément central (910) situé de manière à correspondre à la deuxième zone et à la troisième zone (470C) du panneau de numérisation, formé d'un matériau conducteur et relié à la plaque de renfort ; et
un élément de blindage (821) incluant un matériau de blindage magnétique, et disposé entre la deuxième zone du panneau de numérisation (470) et l'élément d'aimant (511),
où l'élément central est disposé entre l'élément de blindage et l'élément d'aimant.

2. Dispositif électronique (100, 200) selon la revendication 1, comprenant en outre :
un élément de support (262) disposé dans une première direction par rapport à la plaque de renfort (461) ; et
un élément étanche (481) disposé entre l'élément de support (262) et la plaque de renfort (461), et configuré pour fixer la plaque de renfort (461) à l'élément de support (262) et pour assurer l'étanchéité entre l'élément de support (262) et la plaque de renfort (461).

3. Dispositif électronique (100, 200) selon la revendication 1, comprenant en outre une feuille conductrice (880) disposée entre le panneau de numérisation (470) et la plaque de renfort (461) à un emplacement correspondant à la première zone (470A) du panneau de numérisation (470).

4. Dispositif électronique (100, 20) selon la revendication 1, où l'élément central (910) est formé d'un seul tenant avec la plaque de renfort (461).

5. Dispositif électronique (100, 200) selon la revendication 4, où l'élément central (910) est formé de manière à commencer à partir de la plaque de renfort (461) correspondant à la première zone (470A) du panneau de numérisation (470), à être plié au niveau d'une section partielle de l'élément central (910), et à s'étendre jusqu'à un emplacement correspondant à la deuxième zone (470B) du panneau de numérisation (470).

6. Dispositif électronique (100, 200) selon la revendication 1, où l'élément central (910) est formé séparément de la plaque de renfort (461) et est connecté électriquement à la plaque de renfort (461) par un élément de connexion conducteur (920) disposé entre l'élément central (910) et la plaque de renfort (461).

7. Dispositif électronique (100, 200) selon la revendication 1, où l'élément de blindage comprend :
un premier élément de blindage (810) incluant un matériau de blindage magnétique, disposé entre la deuxième zone (470B) du panneau de numérisation (470) et l'élément central (910), et entrant en contact étroit avec la deuxième zone (470B) du panneau de numérisation (470) ; et
un deuxième élément de blindage (820) disposé à un emplacement correspondant à la deuxième zone (470B) du panneau de numérisation, et positionné entre l'élément d'aimant et l'élément central.

8. Dispositif électronique selon la revendication 1, où le panneau de numérisation (470) comprend en outre une quatrième zone (470D) configurée pour être plus adjacente à l'élément latéral (213, 223) que la deuxième zone (470B), et pour chevaucher un boîtier latéral au moins partiellement disposé sur un bord d'une surface avant du dispositif électronique lorsqu'il est vu depuis la surface avant du dispositif électronique, et
où l'élément central (910) a une extrémité connectée électriquement à la plaque de renfort (461) et est configuré pour s'étendre jusqu'à la quatrième zone (470D) du panneau de numérisation (470).

9. Dispositif électronique selon la revendication 1, où l'élément central s'étend au moins partiellement dans la première zone du panneau de numérisation et est en contact avec une surface arrière de la plaque de renfort,
où le dispositif électronique comprend en outre une couche de protection (1030) positionnée dans la première zone (470A) du panneau de numérisation (470) et située sur la surface arrière de la plaque de renfort (461) sans chevaucher l'élément central lorsqu'il est vu depuis une surface avant du dispositif électronique.

10. Dispositif électronique (100, 200) selon la revendication 9, comprenant en outre un élément de blindage (821) incluant un matériau de blindage magnétique, et disposé sur une surface arrière du panneau de numérisation (470).

11. Dispositif électronique (100, 200) selon la revendication 9, où au moins une partie de l'élément central (910) est disposée pour entrer en contact étroit avec la couche de protection (1030) sur une surface arrière de la plaque de renfort (461).

12. Dispositif électronique (100, 200) selon la revendication 9, où l'élément d'aimant (511) est situé à un angle du dispositif électronique (100, 200).

13. Dispositif électronique (100, 200) selon la revendication 9, où la couche de protection (1030) comprend une zone de retrait (1030A) retirée au moins partiellement sur la première zone (470A) du panneau de numérisation, et où l'élément central (910) est configuré pour s'étendre de la deuxième zone (470B) du panneau de numérisation (470) jusqu'à la zone de retrait (1030A) située dans la première zone (470A).

14. Dispositif électronique (100, 20) selon la revendication 1,
où une distance (L2) entre le panneau de numérisation et l'élément central est supérieure à une distance (L1) entre le panneau de numérisation et la plaque de renfort.
